# EUROPEAN PATENT APPLICATION

(11) **EP 3 826 186 A1**
(43) Date of publication of application: **26.05.2021**
(21) Application number: 19907363.6
(22) Date of filing: 31.12.2019
(51) Int. Cl.: H04B 1/10, H04B 1/16, H03F 1/26, H03F 3/45

(54) **RECEIVER AND LOW-NOISE AMPLIFIER**

(30) Priority: 31.12.2018 CN 201811651021
(71) Applicant: HUAWEI TECHNOLOGIES CO., LTD., Shenzhen, Guangdong 518129 (CN)
(72) Inventor: YANG, Kaituo, Singapore 639798 (SG); BOON, Chirn Chye, Singapore 639798 (SG); CHENG, Qianfu, Shenzhen, Guangdong 518129 (CN); ZHANG, Junping, Shenzhen, Guangdong 518129 (CN)
(74) Representative: MERH-IP Matias Erny Reichl Hoffmann Patentanwälte PartG mbB
(86) International application number: PCT/CN2019/130939
(87) International publication number: WO 2020/140918

(57) **Abstract**

A receiver and a low noise amplifier are provided. The receiver includes a primary signal pathway, an auxiliary signal pathway, a combiner circuit, and an intermediate frequency amplifier circuit. The primary signal pathway includes a gate series inductor, a first common-source amplifier circuit, and a frequency mixing circuit, where an input end of the primary signal pathway is connected to an input end of the first common-source amplifier circuit by using the gate series inductor, an output end of the first common-source amplifier circuit is connected to an input end of the frequency mixing circuit, an output end of the frequency mixing circuit is connected to a first input end of the combiner circuit, and an output end of the combiner circuit is connected to an input end of the intermediate frequency amplifier circuit. The auxiliary signal pathway includes a second common-source amplifier circuit and a frequency mixing and phase shift circuit, where an input end of the auxiliary signal pathway is connected to an input end of the second common-source amplifier circuit, an output end of the second common-source amplifier circuit is connected to an input end of the frequency mixing and phase shift circuit, and an output end of the frequency mixing and phase shift circuit is connected to a second input end of the combiner circuit. The solutions in this application help improve system integration and implement a lower noise figure.

## Description

### TECHNICAL FIELD

This application relates to the field of communications technologies and electronic technologies, and in particular, to a receiver and a low noise amplifier.

### BACKGROUND

Currently, for most wireless communications receiving systems, a low noise figure (NF, Noise Figure) indicates that higher sensitivity can be implemented. Generally, for two communications systems with different sensitivity, to meet a requirement of the same signal-to-noise ratio (SNR, Signal to Noise Ratio), a system with higher sensitivity can implement wider coverage in comparison with a system with lower sensitivity. In addition, for the same distance, the system with the higher sensitivity can implement a higher signal-to-noise ratio and a faster data rate in comparison with the system with the lower sensitivity. Therefore, for a receiver (Receiver), a lower noise figure is almost equivalent to better communication quality. Implementing the lower noise figure is also a research hotspot of the receiver.

Herein, 5 GHz to 6 GHz is one of important frequency bands in a WLAN communications system, and 5 GHz to 6 GHz having advantages of a wide frequency band is to be applied to a 5th generation "new radio (New Radio)" system. In comparison with a low frequency, 5 GHz to 6 GHz can be used to provide a higher data rate. According to the Friis transmission equation (Friis Transmission Equation), a radio wave with a higher frequency is attenuated more in spatial transmission. Therefore, for the same transmission distance, a 5 GHz WLAN signal is attenuated more than a 2.4 GHz WLAN signal. The 5.5 GHz signal and the 2.4 GHz signal are used as an example. After being transmitted for the same distance, the 5.5 GHz signal is attenuated by 7.2 dB more than the 2.4 GHz signal. For an SNR at a receive end, an SNR of the former is also 7.2 dB less than an SNR of the latter. Therefore, to meet a specific bit error rate, a transmission range of 5.5 GHz is usually smaller than that of 2.4 GHz. A conventional 5 GHz WLAN receiver that uses a complementary metal-oxide-semiconductor (CMOS, Complementary Metal-Oxide-Semiconductor) technology may implement a noise figure of 3 dB to 6 dB. To implement a relatively low noise figure at a relatively high frequency, the conventional receiver usually requires large power consumption and requires a relatively large quantity of off-chip inductors, thereby reducing system integration and area use.

### SUMMARY

Embodiments of this application provide a receiver and a low noise amplifier.

According to a first aspect, an embodiment of this application provides a receiver. The receiver may include a primary signal pathway, an auxiliary signal pathway, a combiner circuit, and an intermediate frequency amplifier circuit.

The primary signal pathway includes a gate series inductor L1, a first common-source amplifier circuit, and a frequency mixing circuit. An input end of the primary signal pathway is connected to an input end of the first common-source amplifier circuit by using the gate series inductor. An output end of the first common-source amplifier circuit is connected to an input end of the frequency mixing circuit. An output end of the frequency mixing circuit is connected to a first input end of the combiner circuit. An output end of the combiner circuit is connected to an input end of the intermediate frequency amplifier circuit.

The gate series inductor L1 is, for example, an on-chip inductor.

The auxiliary signal pathway includes a second common-source amplifier circuit and a frequency mixing and phase shift circuit. An input end of the auxiliary signal pathway is connected to an input end of the second common-source amplifier circuit. An output end of the second common-source amplifier circuit is connected to an input end of the frequency mixing and phase shift circuit. An output end of the frequency mixing and phase shift circuit is connected to a second input end of the combiner circuit.

It can be learned that the gate series inductor L1 is introduced into the foregoing architecture of the receiver and the gate series inductor L1 is an on-chip inductor. This facilitates implementing a relatively low noise figure at relatively low power consumption. In addition, due to use of the on-chip inductor, system integration and area use are improved.

In some possible implementations, the first common-source amplifier circuit includes:
a first PMOS transistor Q1, a second NMOS transistor Q2, a first resistor R1, and a first capacitor C1.

A source of the first PMOS transistor Q1 is connected to a power supply end. A gate of the first PMOS transistor Q1 is connected to a gate of the second NMOS transistor Q2. The gate of the first PMOS transistor Q1 is further connected to a drain of the first PMOS transistor Q1 by using the first resistor R1. The drain of the first PMOS transistor Q1 is connected to a drain of the second NMOS transistor Q2. The drain of the first PMOS transistor Q1 is further connected to the output end of the first common-source amplifier circuit by using the first capacitor C1. The gate of the first PMOS transistor Q1 is the input end of the first common-source amplifier circuit.

A source of the second NMOS transistor Q2 is connected to the ground. The gate of the second NMOS transistor Q2 is connected to the drain of the second NMOS transistor Q2 by using the first resistor R1.

In some possible implementations, the receiver further includes a seventh capacitor C7.

The second common-source amplifier circuit includes:
a third PMOS transistor Q3, a fourth NMOS transistor Q4, a second resistor R2, and a second capacitor C2.

A source of the third PMOS transistor Q3 is connected to a power supply end. A gate of the third PMOS transistor Q3 is connected to a gate of the fourth NMOS transistor Q4. The gate of the third PMOS transistor Q3 is further connected to a drain of the third PMOS transistor Q3 by using the second resistor R2. The drain of the third PMOS transistor Q3 is connected to a drain of the fourth NMOS transistor Q4. The drain of the third PMOS transistor Q3 is further connected to the output end of the second common-source amplifier circuit by using the second capacitor C2. The gate of the third PMOS transistor Q2 is the input end of the second common-source amplifier circuit.

A source of the fourth NMOS transistor Q4 is connected to the ground. The gate of the fourth NMOS transistor Q4 is connected to the drain of the fourth NMOS transistor Q4 by using the second resistor R2.

The gate of the fourth NMOS transistor Q4 is further connected to the gate of the third PMOS transistor Q3 by using a first inductor L1.

The gate of the fourth NMOS transistor Q4 is further connected to an input end of the receiver by using the seventh capacitor C7.

In some possible implementations, the frequency mixing circuit includes a fifth NMOS transistor Q5, a sixth NMOS transistor Q6, a seventh NMOS transistor Q7, and an eighth NMOS transistor Q8.

The intermediate frequency amplifier circuit includes a first intermediate frequency amplifier IF-AMP 1, a second intermediate frequency amplifier IF-AMP 2, a third variable resistor R3, a third variable capacitor C3, a fourth variable resistor R4, a fourth variable capacitor C4, a fifth variable resistor R5, a fifth variable capacitor C5, a sixth variable resistor R6, and a sixth variable capacitor C6.

A gate of the fifth NMOS transistor Q5 is connected to an output end of a first local oscillator signal Lo1.

A drain of the fifth NMOS transistor Q5 is connected to the output end of the first common-source amplifier circuit. A source of the fifth NMOS transistor Q5 is connected to a positive input end of the first intermediate frequency amplifier IF-AMP 1. The drain of the fifth NMOS transistor Q5 is further separately connected to a drain of the sixth NMOS transistor Q6, a drain of the seventh NMOS transistor Q7, and a drain of the eighth NMOS transistor Q8.

A gate of the sixth NMOS transistor Q6 is connected to an output end of a second local oscillator signal Lo2.

A source of the sixth NMOS transistor Q6 is connected to a negative input end of the first intermediate frequency amplifier IF-AMP 1.

A gate of the seventh NMOS transistor Q7 is connected to an output end of a third local oscillator signal Lo3.

A source of the seventh NMOS transistor Q7 is connected to a positive input end of the second intermediate frequency amplifier IF-AMP 2.

A gate of the eighth NMOS transistor Q8 is connected to the output end of the second local oscillator signal Lo2.

A source of the eighth NMOS transistor Q8 is connected to a negative input end of the second intermediate frequency amplifier IF-AMP 2.

The third variable resistor R3 is connected in parallel to the third variable capacitor C3.

The positive input end of the first intermediate frequency amplifier IF-AMP 1 is connected to a negative output end of the first intermediate frequency amplifier IF-AMP 1 by using the third variable capacitor C3.

The fourth variable resistor R4 is connected in parallel to the fourth variable capacitor C4.

The negative input end of the first intermediate frequency amplifier IF-AMP 1 is connected to a positive output end of the first intermediate frequency amplifier IF-AMP 1 by using the fourth variable capacitor C4.

The fifth variable resistor R5 is connected in parallel to the fifth variable capacitor C5.

The positive input end of the second intermediate frequency amplifier IF-AMP 2 is connected to a negative output end of the second intermediate frequency amplifier IF-AMP 2 by using the fifth variable capacitor C5.

The sixth variable resistor R6 is connected in parallel to the sixth variable capacitor C6.

The negative input end of the second intermediate frequency amplifier IF-AMP 2 is connected to a positive output end of the second intermediate frequency amplifier IF-AMP 2 by using the fourth variable capacitor C6.

In some possible implementations, the frequency mixing and phase shift circuit includes:
a ninth NMOS transistor Q9, a tenth NMOS transistor Q10, an eleventh NMOS transistor Q11, and a twelfth NMOS transistor Q12.

A gate of the ninth NMOS transistor Q9 is connected to the output end of the first local oscillator signal Lo1.

A drain of the ninth NMOS transistor Q9 is connected to the output end of the second common-source amplifier circuit. A source of the ninth NMOS transistor Q9 is connected to the positive input end of the first intermediate frequency amplifier IF-AMP 1. The drain of the ninth NMOS transistor Q9 is further separately connected to a drain of the tenth NMOS transistor Q10, a drain of the eleventh NMOS transistor Q11, and a drain of the twelfth NMOS transistor Q12.

A gate of the tenth NMOS transistor Q10 is connected to the output end of the second local oscillator signal Lo2.

A source of the tenth NMOS transistor Q10 is connected to the negative input end of the first intermediate frequency amplifier IF-AMP 1.

A gate of the eleventh NMOS transistor Q11 is connected to the output end of the third local oscillator signal Lo3.

A source of the eleventh NMOS transistor Q11 is connected to the positive input end of the second intermediate frequency amplifier IF-AMP 2.

A gate of the twelfth NMOS transistor Q12 is connected to an output end of a fourth local oscillator signal Lo4.

A source of the twelfth NMOS transistor Q12 is connected to the negative input end of the second intermediate frequency amplifier IF-AMP 2.

According to a second aspect, an embodiment of this application provides a low noise amplifier. The low noise amplifier includes a complementary common-source input stage, an inter-stage matching and coupling network, and a common-gate output stage. The complementary common-source input stage and the common-gate output stage are coupled by using the inter-stage matching and coupling network. For example, the complementary common-source input stage, the inter-stage matching and coupling network, and the common-gate output stage all use fully integrated on-chip elements.

It can be learned that the low noise amplifier uses a three-stage architecture, and the complementary common-source input stage, the inter-stage matching and coupling network, and the common-gate output stage all use fully integrated on-chip elements. This facilitates implementing a relatively low noise figure at relatively low power consumption. In addition, due to use of the on-chip elements, system integration and area use are improved.

In some possible implementations, the complementary common-source input stage includes:
a first resistor RF1, a second resistor RF2, a third PMOS transistor Q3, a fourth PMOS transistor Q4, a fifth NMOS transistor Q5, and a sixth NMOS transistor Q6.

The inter-stage matching and coupling network includes a second capacitor C2, a third capacitor C3, a fourth capacitor C4, a fifth capacitor C5, and a second inductor L2.

The common-gate output stage includes a first inductor L1, a first capacitor C1, a first NMOS transistor Q1, and a second NMOS transistor Q2.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a source of the fourth PMOS transistor Q4.

A gate of the fourth PMOS transistor Q4 is connected to the negative input end of the complementary common-source input stage.

A center tap of the second inductor L2 is connected to the source of the third PMOS transistor Q3 and the source of the fourth PMOS transistor Q4, and the center tap of the second inductor L2 is further connected to the ground by using the fifth capacitor C5.

The second inductor L2 is connected in parallel to the second capacitor C2. A source of the first NMOS transistor Q1 is connected to a source of the second NMOS transistor Q2 by using the second capacitor C2. The source of the first NMOS transistor Q1 is further connected to the drain of the third PMOS transistor Q3 by using the third capacitor C3. The source of the second NMOS transistor Q2 is further connected to the drain of the fourth PMOS transistor Q4 by using the fourth capacitor C4.

A drain of the first NMOS transistor Q1 is connected to a drain of the second NMOS transistor Q2 by using the first capacitor C1.

The first capacitor C1 is connected in parallel to the first inductor L1.

A center tap of the first inductor L1 is connected to a power supply end.

A gate of the first NMOS transistor Q1 and a gate of the second NMOS transistor Q2 are connected to the power supply end.

The drain of the first NMOS transistor Q1 is a positive output end of the common-gate output stage.

The drain of the second NMOS transistor Q2 is a negative output end of the common-gate output stage.

In some possible implementations, the complementary common-source input stage includes a first resistor RF1, a third PMOS transistor Q3, and a fifth NMOS transistor Q5.

The inter-stage matching and coupling network includes a second capacitor C2, a third capacitor C3, a fifth capacitor C5, and a second inductor L2.

The common-gate output stage includes a first inductor L1, a first capacitor C1, and a first NMOS transistor Q1.

A gate of the fifth NMOS transistor Q5 is connected to an input end of the complementary common-source input stage. A drain of the fifth NMOS transistor Q5 is connected to the input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the input end of the complementary common-source input stage. A source of the third PMOS transistor Q3 is connected to a source of the first NMOS transistor Q1 by using the second inductor L2. The source of the third PMOS transistor Q3 is further connected to the ground by using the fifth capacitor C5.

The source of the first NMOS transistor Q1 is connected to the ground by using the second capacitor C2. The source of the first NMOS transistor Q1 is further connected to the drain of the third PMOS transistor Q3 by using the third capacitor C3.

A drain of the first NMOS transistor Q1 is connected to an output end of the common-gate output stage by using the first capacitor C1.

The drain of the first NMOS transistor Q1 is connected to a power supply end by using the first inductor L1.

The gate of the first NMOS transistor Q1 is connected to the power supply end.

In some possible implementations, the complementary common-source input stage includes:
a first resistor RF1, a second resistor RF2, a third PMOS transistor Q3, a fourth PMOS transistor Q4, a fifth NMOS transistor Q5, and a sixth NMOS transistor Q6.

The inter-stage matching and coupling network includes a first capacitor C1, a second capacitor C2, a fifth variable capacitor C5, and a second inductor L2.

The common-gate output stage includes:
a first inductor L1, a third capacitor C3, a fourth capacitor C4, a first NMOS transistor Q1, a second NMOS transistor Q2, a third resistor R3, a fourth resistor R4, and a sixth variable capacitor C6.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A gate of the fourth PMOS transistor Q4 is connected to the negative input end of the complementary common-source input stage. A source of the fourth PMOS transistor Q4 is connected to a power supply end. The drain of the fourth PMOS transistor Q4 is connected to a source of the second NMOS transistor Q2 by using the second capacitor C2.

A center tap of the second inductor L2 is connected to the ground.

The second inductor L2 is connected in parallel to the fifth variable capacitor C5.

The source of the first NMOS transistor Q1 is connected to the source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a drain of the second NMOS transistor Q2 by using the sixth variable capacitor C6.

The source of the second NMOS transistor Q2 is further connected to the gate of the first NMOS transistor Q1 by using the fourth capacitor C4.

The sixth variable capacitor C6 is connected in parallel to the first inductor L1.

A center tap of the first inductor L1 is connected to a power supply end.

The drain of the first NMOS transistor Q1 is a positive output end of the common-gate output stage.

The drain of the second NMOS transistor Q2 is a negative output end of the common-gate output stage.

In some possible implementations, the complementary common-source input stage includes a first resistor RF1, a third PMOS transistor Q3, and a fifth NMOS transistor Q5.

The inter-stage matching and coupling network includes a first capacitor C1, a second capacitor C2, a fifth variable capacitor C5, and a second inductor L2.

The common-gate output stage includes:
a first inductor L1, a third capacitor C3, a fourth capacitor C4, a first NMOS transistor Q1, a second NMOS transistor Q2, a third resistor R3, a fourth resistor R4, and a sixth variable capacitor C6.

A gate of the fifth NMOS transistor Q5 is connected to an input end of the complementary common-source input stage. A drain of the fifth NMOS transistor Q5 is connected to the input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A center tap of the second inductor L2 is connected to the ground.

The second inductor L2 is connected in parallel to the fifth variable capacitor C5.

The source of the first NMOS transistor Q1 is connected to a source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a drain of the second NMOS transistor Q2 by using the sixth variable capacitor C6.

The source of the second NMOS transistor Q2 is further connected to the gate of the first NMOS transistor Q1 by using the fourth capacitor C4.

The sixth variable capacitor C6 is connected in parallel to the first inductor L1.

A center tap of the first inductor L1 is connected to a power supply end.

The drain of the first NMOS transistor Q1 is a positive output end of the common-gate output stage.

The drain of the second NMOS transistor Q2 is a negative output end of the common-gate output stage.

In some possible implementations, the complementary common-source input stage includes:
a first resistor RF1, a second resistor RF2, a third PMOS transistor Q3, a fourth PMOS transistor Q4, a fifth NMOS transistor Q5, and a sixth NMOS transistor Q6.

The inter-stage matching and coupling network includes a first capacitor C1, a second capacitor C2, a fifth variable capacitor C5, and a second inductor L2.

The common-gate output stage includes:
a first inductor L1, a third capacitor C3, a fourth capacitor C4, a first NMOS transistor Q1, a second NMOS transistor Q2, a third resistor R3, a fourth resistor R4, a sixth variable capacitor C6, a seventh NMOS transistor Q7, and an eighth NMOS transistor Q8.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A gate of the fourth PMOS transistor Q4 is connected to the negative input end of the complementary common-source input stage. A source of the fourth PMOS transistor Q4 is connected to a power supply end. The drain of the fourth PMOS transistor Q4 is connected to a source of the second NMOS transistor Q2 by using the second capacitor C2.

A center tap of the second inductor L2 is connected to the ground.

The second inductor L2 is connected in parallel to the fifth variable capacitor C5.

The source of the first NMOS transistor Q1 is connected to the source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a source of the seventh NMOS transistor Q7.

The source of the second NMOS transistor Q2 is further connected to the gate of the first NMOS transistor Q1 by using the fourth capacitor C4.

A drain of the second NMOS transistor Q2 is connected to a source of the eighth NMOS transistor Q8.

A drain of the seventh NMOS transistor Q7 is connected to a drain of the eighth NMOS transistor Q8 by using the sixth variable capacitor C6.

A gate of the seventh NMOS transistor Q7 is connected to a gate of the eighth NMOS transistor Q8.

The sixth variable capacitor C6 is connected in parallel to the first inductor L1.

A center tap of the first inductor L1 is connected to a power supply end.

The drain of the seventh NMOS transistor Q7 is a positive output end of the common-gate output stage.

The drain of the eighth NMOS transistor Q8 is a negative output end of the common-gate output stage.

In some possible implementations, the complementary common-source input stage includes:
a first resistor RF1, a third PMOS transistor Q3, and a fifth NMOS transistor Q5.

The inter-stage matching and coupling network includes a first capacitor C1, a fifth variable capacitor C5, and a second inductor L2.

The common-gate output stage includes a first inductor L1, a third capacitor C3, a fourth capacitor C4, a first NMOS transistor Q1, a second NMOS transistor Q2, a third resistor R3, a fourth resistor R4, a sixth variable capacitor C6, a seventh NMOS transistor Q7, and an eighth NMOS transistor Q8.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the positive input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A center tap of the second inductor L2 is connected to the ground.

The second inductor L2 is connected in parallel to the fifth variable capacitor C5.

The source of the first NMOS transistor Q1 is connected to a source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a source of the seventh NMOS transistor Q7.

The source of the second NMOS transistor Q2 is further connected to the gate of the first NMOS transistor Q1 by using the fourth capacitor C4.

A drain of the second NMOS transistor Q2 is connected to a source of the eighth NMOS transistor Q8.

A drain of the seventh NMOS transistor Q7 is connected to a drain of the eighth NMOS transistor Q8 by using the sixth variable capacitor C6.

A gate of the seventh NMOS transistor Q7 is connected to a gate of the eighth NMOS transistor Q8.

The sixth variable capacitor C6 is connected in parallel to the first inductor L1.

A center tap of the first inductor L1 is connected to a power supply end.

The drain of the seventh NMOS transistor Q7 is a positive output end of the common-gate output stage.

The drain of the eighth NMOS transistor Q8 is a negative output end of the common-gate output stage.

According to a third aspect, an embodiment of this application provides a receiver. The receiver includes any low noise amplifier provided in the embodiment of this application.

### BRIEF DESCRIPTION OF DRAWINGS

The following describes the accompanying drawings related to the embodiments or the background of this application.
FIG. 1-A is a schematic architectural diagram of a receiver according to an embodiment of this application;
FIG. 1-B-1 and FIG. 1-B-2 are a schematic structural diagram of a circuit of another receiver according to an embodiment of this application;
FIG. 1-C is a schematic waveform diagram of a local oscillator signal according to an embodiment of this application;
FIG. 1-D to FIG. 1-F are schematic diagrams of simulation effects according to an embodiment of this application;
FIG. 2 is a schematic structural diagram of a low noise amplifier according to an embodiment of this application;
FIG. 3-A is a schematic structural diagram of a specific circuit of another low noise amplifier according to an embodiment of this application;
FIG. 3-B is a schematic structural diagram of a specific circuit of another low noise amplifier according to an embodiment of this application;
FIG. 4-A and FIG. 4-B are schematic diagrams of other simulation effects according to an embodiment of this application;
FIG. 5-A is a schematic structural diagram of a specific circuit of another low noise amplifier according to an embodiment of this application;
FIG. 5-B is a schematic structural diagram of a specific circuit of another low noise amplifier according to an embodiment of this application;
FIG. 6-A and FIG. 6-B are schematic diagrams of other simulation effects according to an embodiment of this application;
FIG. 7-A is a schematic structural diagram of a specific circuit of another low noise amplifier according to an embodiment of this application;
FIG. 7-B is a schematic structural diagram of a specific circuit of another low noise amplifier according to an embodiment of this application;
FIG. 8-A and FIG. 8-B are schematic diagrams of other simulation effects according to an embodiment of this application; and
FIG. 9 is a schematic architectural diagram of another receiver according to an embodiment of this application.

### DESCRIPTION OF EMBODIMENTS

The following describes the embodiments of this application with reference to the accompanying drawings in the embodiments of this application.

A 5 GHz to 6 GHz frequency band has been widely used in a WLAN communications system. This frequency band is also to be used in future 5G-NR. To enable a receiver system to implement higher communication quality and a larger coverage range, it is imperative to implement a lower noise figure in this frequency range. A conventional structure requires relatively high power consumption and a relatively large area to implement a low noise figure. This application proposes a receiver architecture applicable to a relatively high frequency. A noise cancellation technology is used, and a low noise figure is implemented at the relatively high frequency based on moderate power consumption and an on-chip inductor.

The embodiments of this application provide some new receiver structures in which the noise cancellation technology is used. These structures may be applied to a relatively high frequency of 5 GHz to 6 GHz but are not limited thereto. A low noise figure less than 2 dB may be implemented with moderate power consumption by introducing an on-chip inductor.

In addition, to meet a conventional receiver architecture, the embodiments of this application also provide some LNA structures with low power consumption and low noise figures.

The embodiments of this application provide a new receiver that has a low noise figure and that is applicable to a relatively high frequency. An on-chip inductor is introduced to implement input matching. In addition, the noise figure less than 2 dB can be implemented. The receiver has a relatively high linearity and moderate power consumption. The receiver may be applied to a 5G-NR receiver system in a 5 GHz WLAN.

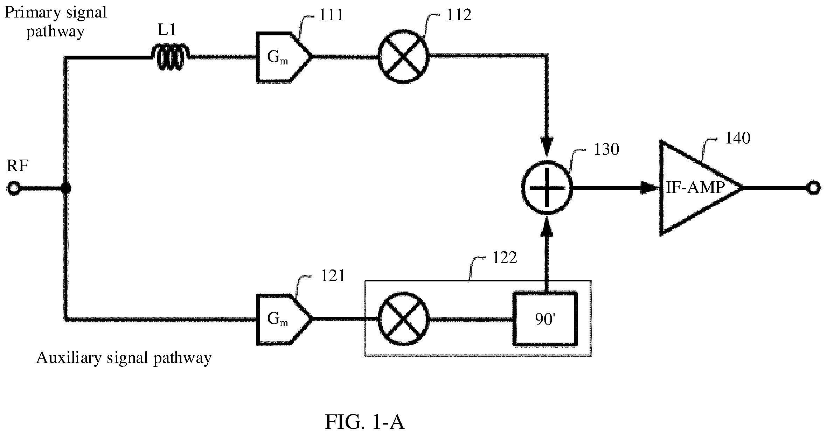

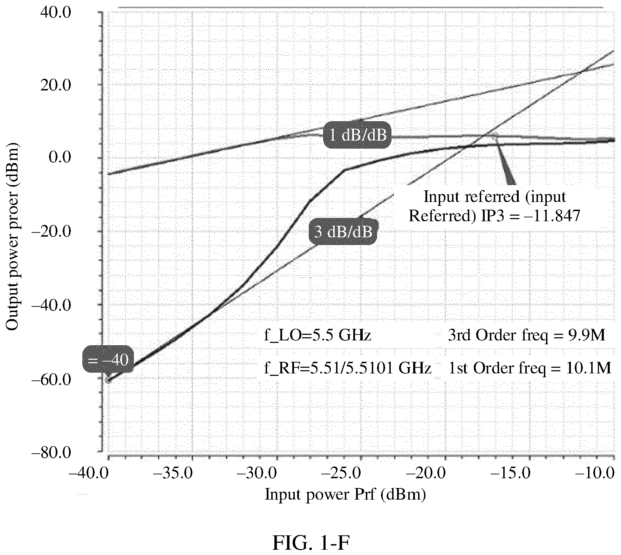

Referring to FIG. 1-A, an embodiment of this application provides a receiver. The receiver may include a primary signal pathway, an auxiliary signal pathway, a combiner circuit, and an intermediate frequency amplifier circuit.

The primary signal pathway includes a gate series inductor L1, a first common-source amplifier circuit 111, and a first frequency mixing circuit 112. An input end of the primary signal pathway is connected to an input end of the first common-source amplifier circuit 111 by using the gate series inductor L1. An output end of the first common-source amplifier circuit 111 is connected to an input end of the first frequency mixing circuit 112. An output end of the first frequency mixing circuit 112 is connected to a first input end of the combiner circuit 130. An output end of the combiner circuit 130 is connected to an input end of the intermediate frequency amplifier circuit 140. The gate series inductor L1 is, for example, an on-chip inductor.

The auxiliary signal pathway may include a second common-source amplifier circuit 121 and a second frequency mixing and phase shift circuit 122 (the frequency mixing and phase shift circuit 122 has a frequency mixing function and a function of a 90-degree phase shifter). An input end of the auxiliary signal pathway is connected to an input end of the second common-source amplifier circuit 121. An output end of the second common-source amplifier circuit 121 is connected to an input end of the second frequency mixing and phase shift circuit 122. An output end of the second frequency mixing and phase shift circuit 122 is connected to a second input end of the combiner circuit 130.

In the solution of this embodiment, noise of the gate inductor in the primary signal pathway may be cancelled by using the auxiliary signal pathway. The input matching may be jointly completed by the primary signal pathway and the auxiliary signal pathway. The primary signal pathway includes the gate series inductor, the common-source amplifier circuit, the frequency mixing circuit, and the like. The auxiliary signal pathway includes the common-source amplifier circuit, the frequency mixing and phase shift circuit (frequent mixing and a 90-degree phase shifter) circuit, and the like. An output signal of the frequency mixing circuit of the primary signal pathway and an output signal that is obtained after frequency mixing and 90-degree phase shift and that is of the auxiliary signal pathway are added and are amplified and output by the intermediate frequency amplifier circuit (such as a baseband amplifier). In the primary signal pathway, the gate inductor still contributes the most to noise. Structure configuration of the entire receiver is to cancel the noise contribution of the gate inductor at an output end.

To simplify analysis, parasitic capacitance between a gate and a drain of a common-source input stage is not considered. Similarly, for a wanted signal, a phase at the input end of the primary signal pathway is 0 degrees, and a phase of the wanted signal obtained after down-conversion at an output end of the primary signal pathway is 90 degrees; and a phase at the input end of the auxiliary signal pathway is also 0 degrees, and a phase of the wanted signal obtained after down-conversion at an output end of the auxiliary signal pathway is 180 degrees. For the gate inductor in the primary signal pathway, a phase of the wanted signal at the input end of the primary signal pathway is 0 degrees, and a phase of the wanted signal obtained after down-conversion at the output end of the primary signal pathway is - 90 degrees; and a phase of the wanted signal is also 0 degrees at the input end of the auxiliary signal pathway, and a phase of the anted signal obtained after down-conversion at the output end of the auxiliary signal pathway is 180 degrees. If the auxiliary signal pathway after down-conversion passes a -90-degree phase shifter, a phase of a wanted signal obtained after phase shift in the auxiliary signal pathway is changed to 90 degrees, which is the same as a phase of a wanted signal obtained after down-conversion in the primary signal pathway. A phase of a noise signal obtained after phase shift in the auxiliary signal pathway is changed to 90 degrees, which is opposite to a phase of a noise signal obtained after down-conversion in the primary signal pathway. Therefore, the -90-degree phase shifter adds the signals obtained after down-conversion in the primary signal pathway and the auxiliary signal pathway together. In this way, wanted signals are enhanced, and noise contributions of gate inductors in the primary signal pathway are attenuated, to implement a noise cancellation function, thereby facilitating implementing a low noise figure of sub-2 dB.

In comparison with a conventional technology, the solution in this embodiment provides a relatively simple structure, and a structure of the primary signal pathway and a structure of the auxiliary signal pathway are almost the same. The on-chip inductor L1 is introduced, thereby reducing an area and improving system integration. In addition, power consumption is much lower than that in the conventional technology because the common-source amplifier circuit in the primary signal pathway can provide a greater equivalent transconductance, and the relatively low noise figure can be implemented without an excessively large current.

Some specific circuits of the receiver are described below by using examples.

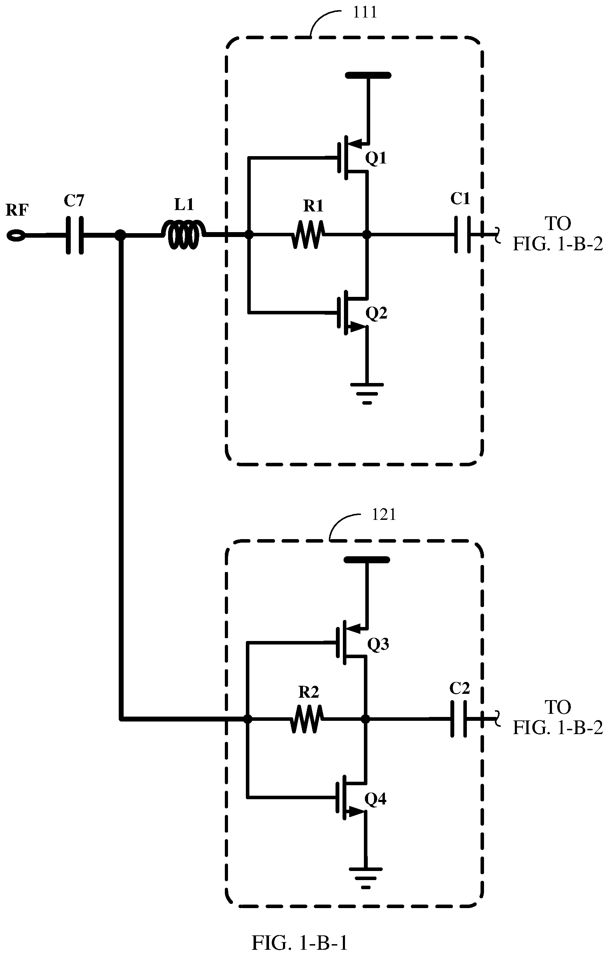

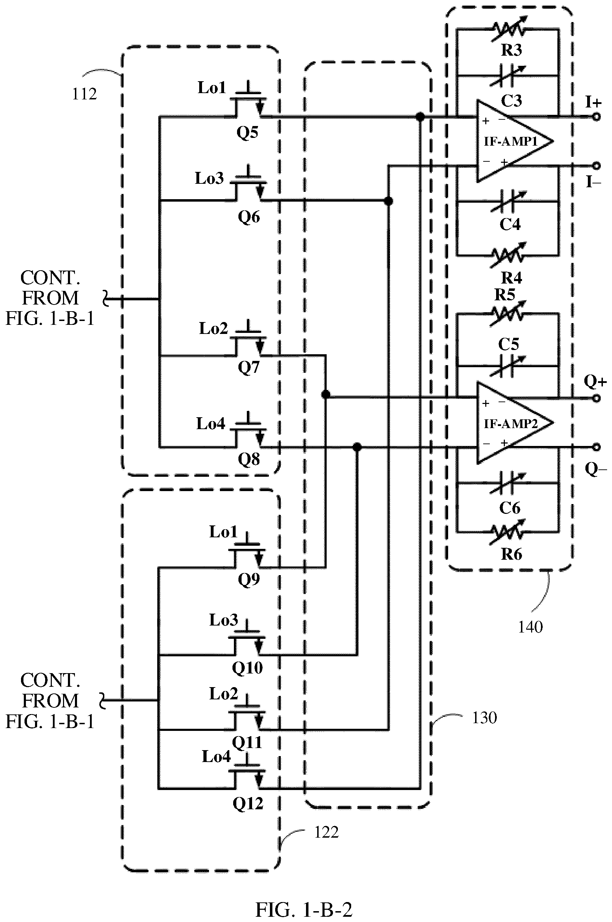

FIG. 1-B-1 and FIG. 1-B-2 are a schematic structural diagram of a possible specific circuit of a receiver according to an example of an embodiment of this application. As shown in the example of FIG. 1-B-1 and FIG. 1-B-2, the first common-source amplifier circuit 111 may include a first PMOS transistor Q1, a second NMOS transistor Q2, a first resistor R1, and a first capacitor C1.

A source of the first PMOS transistor Q1 is connected to a power supply end. A gate of the first PMOS transistor Q1 is connected to a gate of the second NMOS transistor Q2. The gate of the first PMOS transistor Q1 is further connected to a drain of the first PMOS transistor Q1 by using the first resistor R1. The drain of the first PMOS transistor Q1 is connected to a drain of the second NMOS transistor Q2. The drain of the first PMOS transistor Q1 is further connected to an output end of the first common-source amplifier circuit by using the first capacitor C1. The gate of the first PMOS transistor Q1 is an input end of the first common-source amplifier circuit.

A source of the second NMOS transistor Q2 is connected to the ground. The gate of the second NMOS transistor Q2 is connected to the drain of the second NMOS transistor Q2 by using the first resistor R1.

In some possible implementations, as shown in the example of FIG. 1-B-1 and FIG. 1-B-2, the receiver may further include a seventh capacitor C7. The second common-source amplifier circuit 121 may include a third PMOS transistor Q3, a fourth NMOS transistor Q4, a second resistor R2, and a second capacitor C2.

A source of the third PMOS transistor Q3 is connected to a power supply end. A gate of the third PMOS transistor Q3 is connected to a gate of the fourth NMOS transistor Q4. The gate of the third PMOS transistor Q3 is further connected to a drain of the third PMOS transistor Q3 by using the second resistor R2. The drain of the third PMOS transistor Q3 is connected to a drain of the fourth NMOS transistor Q4. The drain of the third PMOS transistor Q3 is further connected to an output end of the second common-source amplifier circuit by using the second capacitor C2. The gate of the third PMOS transistor Q3 is an input end of the second common-source amplifier circuit.

A source of the fourth NMOS transistor Q4 is connected to the ground. The gate of the fourth NMOS transistor Q4 is connected to the drain of the fourth NMOS transistor Q4 by using the second resistor R2.

The gate of the fourth NMOS transistor Q4 is further connected to the gate of the third PMOS transistor Q3 by using the first inductor L1.

The gate of the fourth NMOS transistor Q4 is further connected to an input end of the receiver by using the seventh capacitor C7.

In some possible implementations, as shown in the example of FIG. 1-B-1 and FIG. 1-B-2, the frequency mixing circuit 112 may include a fifth NMOS transistor Q5, a sixth NMOS transistor Q6, a seventh NMOS transistor Q7, and an eighth NMOS transistor Q8.

The intermediate frequency amplifier circuit 140 may include a first intermediate frequency amplifier IF-AMP 1, a second intermediate frequency amplifier IF-AMP 2, a third variable resistor R3, a third variable capacitor C3, a fourth variable resistor R4, a fourth variable capacitor C4, a fifth variable resistor R5, a fifth variable capacitor C5, a sixth variable resistor R6, and a sixth variable capacitor C6.

A gate of the fifth NMOS transistor Q5 is connected to an output end of a first local oscillator signal Lo1.

A drain of the fifth NMOS transistor Q5 is connected to the output end of the first common-source amplifier circuit. A source of the fifth NMOS transistor Q5 is connected to a positive input end of the first intermediate frequency amplifier IF-AMP 1. The drain of the fifth NMOS transistor Q5 is further separately connected to a drain of the sixth NMOS transistor Q6, a drain of the seventh NMOS transistor Q7, and a drain of the eighth NMOS transistor Q8.

A gate of the sixth NMOS transistor Q6 is connected to an output end of a second local oscillator signal Lo2.

A source of the sixth NMOS transistor Q6 is connected to a negative input end of the first intermediate frequency amplifier IF-AMP 1.

A gate of the seventh NMOS transistor Q7 is connected to an output end of a third local oscillator signal Lo3.

A source of the seventh NMOS transistor Q7 is connected to a positive input end of the second intermediate frequency amplifier IF-AMP 2.

A gate of the eighth NMOS transistor Q8 is connected to an output end of a fourth local oscillator signal Lo4.

A source of the eighth NMOS transistor Q8 is connected to a negative input end of the second intermediate frequency amplifier IF-AMP 2.

The third variable resistor R3 is connected in parallel to the third variable capacitor C3.

The positive input end of the first intermediate frequency amplifier IF-AMP 1 is connected to a negative output end of the first intermediate frequency amplifier IF-AMP 1 by using the third variable capacitor C3.

The fourth variable resistor R4 is connected in parallel to the fourth variable capacitor C4.

The negative input end of the first intermediate frequency amplifier IF-AMP 1 is connected to a positive output end of the first intermediate frequency amplifier IF-AMP 1 by using the fourth variable capacitor C4.

The fifth variable resistor R5 is connected in parallel to the fifth variable capacitor C5.

The positive input end of the second intermediate frequency amplifier IF-AMP 2 is connected to a negative output end of the second intermediate frequency amplifier IF-AMP 2 by using the fifth variable capacitor C5.

The sixth variable resistor R6 is connected in parallel to the sixth variable capacitor C6.

The negative input end of the second intermediate frequency amplifier IF-AMP 2 is connected to a positive output end of the second intermediate frequency amplifier IF-AMP 2 by using the sixth variable capacitor C6.

In some possible implementations, as shown in the example of FIG. 1-B-1 and FIG. 1-B-2, the frequency mixing and phase shift circuit 122 may include, for example, a ninth NMOS transistor Q9, a tenth NMOS transistor Q10, an eleventh NMOS transistor Q11, and a twelfth NMOS transistor Q12.

A gate of the ninth NMOS transistor Q9 is connected to the output end of the first local oscillator signal Lo1.

A drain of the ninth NMOS transistor Q9 is connected to the output end of the second common-source amplifier circuit. A source of the ninth NMOS transistor Q9 is connected to the positive input end of the first intermediate frequency amplifier IF-AMP 1. The drain of the ninth NMOS transistor Q9 is further separately connected to a drain of the tenth NMOS transistor Q10, a drain of the eleventh NMOS transistor Q11, and a drain of the twelfth NMOS transistor Q12.

A gate of the tenth NMOS transistor Q10 is connected to the output end of the second local oscillator signal Lo2.

A source of the tenth NMOS transistor Q10 is connected to the negative input end of the first intermediate frequency amplifier IF-AMP 1.

A gate of the eleventh NMOS transistor Q11 is connected to the output end of the third local oscillator signal Lo3.

A source of the eleventh NMOS transistor Q11 is connected to the positive input end of the second intermediate frequency amplifier IF-AMP 2.

A gate of the twelfth NMOS transistor Q12 is connected to an output end of a fourth local oscillator signal Lo4.

A source of the twelfth NMOS transistor Q12 is connected to the negative input end of the second intermediate frequency amplifier IF-AMP 2.

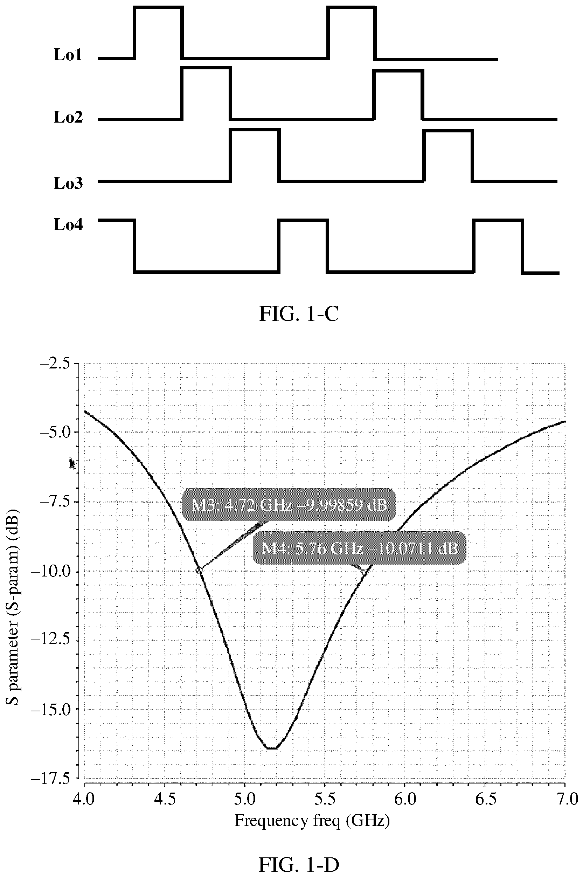

FIG. 1-C shows examples of waveform diagrams of a first local oscillator signal Lo1, a second local oscillator signal Lo2, a third local oscillator signal Lo3, and a fourth local oscillator signal Lo4. Herein, Lo1, Lo2, Lo3, and Lo4 are all rectangular waves, and high-level segments of Lo1, Lo2, Lo3, and Lo4 complementarily overlap.

It may be learned that, in the structure of the receiver shown in FIG. 1-B-1 and FIG. 1-B-2, the primary signal pathway includes the gate series inductor, the common-source amplifier circuit, the passive frequency mixing circuit, and the like; and the auxiliary signal pathway includes the common-source amplifier circuit, the passive frequency mixing circuit, and the like. The common-source amplifier circuits in the two paths are both complementary types, multiplex a direct current bias current, and can be used to implement a relatively large equivalent transconductance. Because the two common-source amplifier circuits are connected to the passive frequency mixing circuits, the common-source amplifier circuits may also be referred to as transconductance amplifiers. The two common-source amplifier circuits provide DC bias voltages through self-biasing. An output of the common-source amplifier circuit is coupled to the next-stage frequency mixing circuit in an alternating current manner. An intermediate direct current blocking capacitor implements a function of isolating a DC bias at a radio frequency end and a DC bias at an intermediate frequency end.

The passive frequency mixing circuits in the two paths both include four channels and are driven by four channels of carriers that do not overlap each other with a duty cycle of 25%. The frequency mixing circuit may implement an impedance transfer function, and may transfer an input impedance of a next-stage TIA to a high frequency after up-conversion, so that an input impedance of the frequency mixing circuit is evenly proportional to the input impedance of the TIA. Because the input impedance of the TIA is relatively small, after the impedance transfer function of the frequency mixing circuit is implemented, the input impedance of the frequency mixing circuit, that is, a load impedance of the common-source amplifier circuit is also relatively small. A function of the common-source amplifier circuit is similar to a transconductance. An input voltage is converted into a current, so that the current flows into the next-stage passive frequency mixing circuit. Therefore, the common-source amplifier circuit herein may also be referred to as a transconductance amplifier. An entire receiver system operates in a current mode, so that the receiver has a high linearity at the same time.

To cancel the input noise contribution of the gate inductor in the primary signal pathway, it may be learned from FIG. 1-A that the signal obtained after down-conversion and 90-degree phase shift in the auxiliary signal pathway and the signal obtained after down-conversion in the primary signal pathway need to be added and jointly amplified by the intermediate frequency amplifier. It may be learned from FIG. 1-B-1 and FIG. 1-B-2 that, the 90-degree phase shift function is implemented through IQ quadrature down-conversion. In four quadrature channels of outputs of the frequency mixing circuit in the auxiliary signal pathway, one corresponding channel of output is selected to be directly connected to one of four quadrature channels of outputs of the frequency mixing circuit in the primary signal pathway. This is equivalent to adding an output that is of the frequency mixing circuit in the auxiliary signal pathway and that is obtained after 90-degree phase shift, and the output of the frequency mixing circuit in the primary signal pathway. Similarly, the four channels of carriers may be extended to eight or more channels of carriers with a duty cycle of 12.5%.

Noise contributions of the gate inductors at two ends (the two ends are the gate of the primary signal pathway and the gate the auxiliary signal pathway) may have just a difference of 90 degrees (because a left impedance of the inductor is a resistor, and a right impedance of the inductor is a capacitor, the difference is 90 degrees). After passing the next-stage frequency mixing circuit, the noise contributions obtain another 90-degree phase shift. The difference becomes 180 degrees in this case. Then, the noise contributions are cancelled through signal addition.

In conclusion, in the circuit architecture of the new receiver in the foregoing example, the inductor is designed to implement input matching at a relatively high frequency (Multi-GHz). The structure is simple. In addition to the inductor, structures of the primary signal pathway and the auxiliary signal pathway are basically the same. By using the noise cancellation technology, input thermal noise of the series inductor can be cancelled by using the auxiliary path, so that the circuit has very good noise performance. In addition, a first stage is a complementary transconductance amplifier sharing a DC bias current. In this case, overall power consumption is not large. In addition, the receiver may operate in the current mode, and have a relatively high linearity.

In comparison with a conventional technology, it facilitates implementing a lower noise figure. In addition, the structure is simpler. This helps reduce an area and improve system integration.

FIG. 1-D to FIG. 1-F show diagrams of simulation effects.

FIG. 1-D shows an example of an input matching simulation result of the circuit shown in FIG. 1-B-1 and FIG. 1-B-2. A target operating frequency herein is 5 GHz and is applicable to a WLAN communications standard. It may be learned from observation that S11 is less than -10 dB within 5 GHz to 5.8 GHz. In this way, input matching is well implemented.

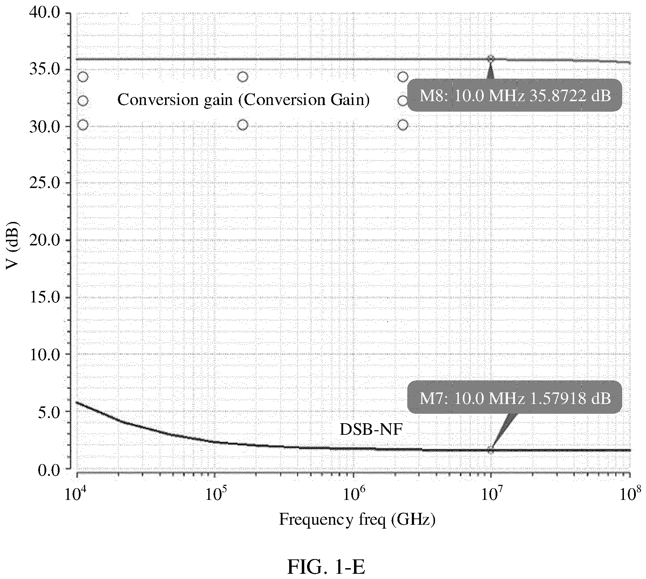

FIG. 1-E shows an example of simulation results of a gain and a noise figure of the circuit shown in FIG. 1-B-1 and FIG. 1-B-2. It may be learned from observation that a maximum gain can reach 35.8 dB, and the gain at 100 MHz is only decreased by 0.5 dB. A dual-sideband noise figure of the receiver is 1.58 dB, and a break frequency is 30 KHz. This proves effectiveness of a noise cancellation function of the circuit in this embodiment.

FIG. 1-E shows an example of a simulation result of an input third-order intercept point (IIP3) of the circuit shown in FIG. 1-B-1 and FIG. 1-B-2. The receiver can implement an IIP3 of -11.8 dBm at the maximum gain, and show a high linearity.

The embodiments of this application further provide some low noise amplifiers.

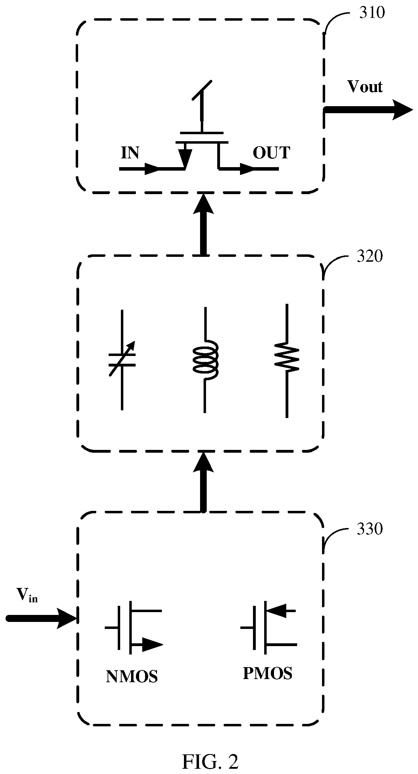

Referring to FIG. 2, an embodiment of this application further provides a low noise amplifier. The low noise amplifier includes:
a complementary common-source (Complementary Common-Source) input stage 330, an inter-stage matching and coupling network 320, and a common-gate output stage 310, where the complementary common-source input stage 330 and the common-gate (Common-Gate) output stage 310 are coupled by using the inter-stage matching and coupling network 320.

The LNA may be used to implement a front end of a receiver. FIG. 2 is an example of a system architecture of a low noise amplifier with a high linearity that is applicable to a receiver architecture according to this application. The low noise amplifier mainly includes three parts: the complementary common-source input stage, the inter-stage matching and coupling network, and the common-gate output stage.

The complementary common-source input stage is constructed based on an NMOS transistor (N-channel field effect transistor) and a PMOS transistor (P-channel field effect transistor). The complementary common-source input stage shares a direct current bias current. An equivalent transconductance of the input stage is increased at the same current consumption. A second-order nonlinearity is partially cancelled, and a third-order nonlinearity is also improved. The inter-stage matching network resonates at an operating frequency, and provides proper alternating current and direct current signal pathways. Different implementation structures correspond to different coupling and matching networks. The common-gate output stage is used to improve isolation between an output end and an input end, thereby increasing circuit stability. In addition, it helps reduce a load function of an output matching network on an input matching network, thereby simplifying a design of the input matching network. The complementary common-source input stage and the common-gate stage may share a direct current bias or may separately use biases. The entire circuit may operate in a narrowband mode or may be configured with a broadband mode. This is determined based on both a specific input/output matching network and an inter-stage coupling network.

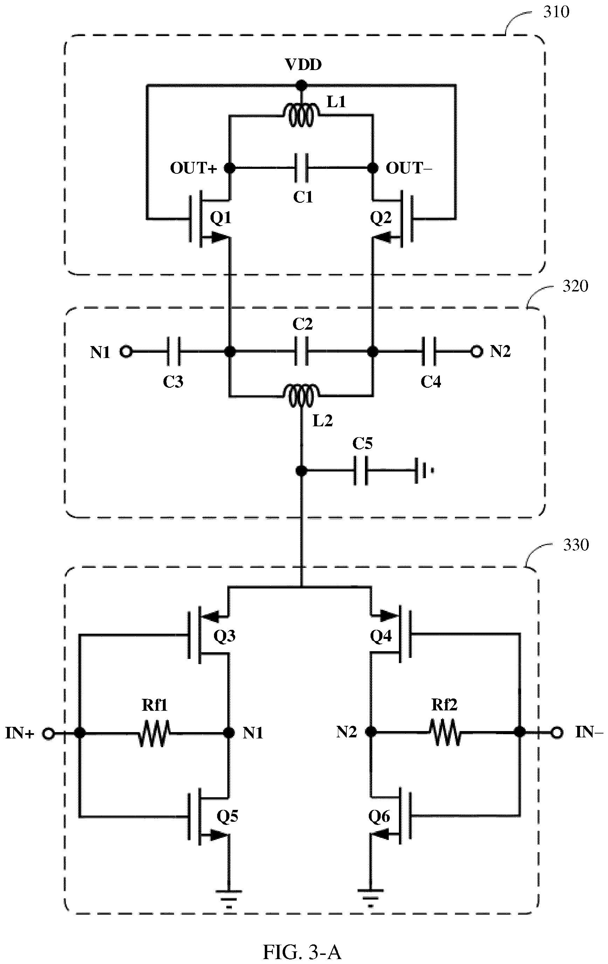

In addition to these three parts, the amplifier may further include an input matching network, an output matching network, and the like. In the figure, the input matching network and the output matching network are shown.FIG. 3-A is a schematic structural diagram of a possible specific circuit of a low noise amplifier according to an example of an embodiment of this application. As shown in the example of FIG. 3-A, a complementary common-source input stage includes a first resistor RF1, a second resistor RF2, a third PMOS transistor Q3, a fourth PMOS transistor Q4, a fifth NMOS transistor Q5, and a sixth NMOS transistor Q6.

An inter-stage matching and coupling network includes a second capacitor C2, a third capacitor C3, a fourth capacitor C4, a fifth capacitor C5, and a second inductor L2.

A common-gate output stage includes a first inductor L1, a first capacitor C1, a first NMOS transistor Q1, and a second NMOS transistor Q2.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a source of the fourth PMOS transistor Q4.

A gate of the fourth PMOS transistor Q4 is connected to the negative input end of the complementary common-source input stage.

A center tap of the second inductor L2 is connected to the source of the third PMOS transistor Q3 and the source of the fourth PMOS transistor Q4, and the center tap of the second inductor L2 is further connected to the ground by using the fifth capacitor C5.

The second inductor L2 is connected in parallel to the second capacitor C2.

A source of the first NMOS transistor Q1 is connected to a source of the second NMOS transistor Q2 by using the second capacitor C2. The source of the first NMOS transistor Q1 is further connected to the drain of the third PMOS transistor Q3 by using the third capacitor C3. The source of the second NMOS transistor Q2 is further connected to the drain of the fourth PMOS transistor Q4 by using the fourth capacitor C4.

A drain of the first NMOS transistor Q1 is connected to a drain of the second NMOS transistor Q2 by using the first capacitor C1.

The first capacitor C1 is connected in parallel to the first inductor L1.

A center tap of the first inductor L1 is connected to a power supply end.

A gate of the first NMOS transistor Q1 and a gate of the second NMOS transistor Q2 are connected to the power supply end.

The drain of the first NMOS transistor Q1 is a positive output end of the common-gate output stage.

The drain of the second NMOS transistor Q2 is a negative output end of the common-gate output stage.

The amplifier of the architecture shown in FIG. 3-A is in a fully differential form. The complementary common-source input stage is constructed by using the NMOS and the PMOS. A gate bias may be provided by using a feedback resistor with a large resistance value (for example, 100 K), so that all the MOS transistors operate in a saturation region. The sources of the PMOS transistors in the two differential paths are connected and provided with a direct current by using a next-stage passive coupling network. In addition, an alternating current capacitor is connected to a node and is connected to the ground so that an alternating current is short-circuited. An alternating current signal is output from a drain node and is coupled to the passive coupling network by using the capacitor C3/C4, which is also the source of the NMOS transistor of the common-gate input stage. The inter-stage passive matching network includes an LC resonant network and the coupling capacitor C3/C4. The inductor in the resonant network is a differential inductor. The center tap of the inductor is connected to the source of the PMOS transistor in the complementary common-source input stage. A direct current is shared. The resonant network is used to implement an alternating current isolation function, so that most alternating current signals flow into the source of the common-gate input stage and are finally amplified at the drain of the common-gate transistor.

Similarly, a drain load is constructed by using the LC resonant network, and resonates at a signal operating frequency and provides a specific gain. In addition, a signal is coupled to a next-stage frequency mixer to a greatest extent. The circuit may operate in a narrowband mode, and may be configured with an input/output matching network. The input/output matching network is not shown in the figure.

The complementary common-source input stage may partially cancel a second-order nonlinearity and improve a third-order nonlinearity. A size ratio of the PMOS transistor and the NMOS transistor is adjusted, to achieve best second-order nonlinearity cancellation effects. The common-source stage and the common-gate stage share the direct current. Some third-order nonlinear intermodulation items appear directly at the output end of the common-gate stage because of an effect of multiplexing the direct current, and are output to the common-gate stage through a common-source amplifier and then are amplified at the output end of the common-gate stage. The third-order nonlinear intermodulation items of the two paths are used to cancel each other, so that the entire circuit can implement a very good IIP3.

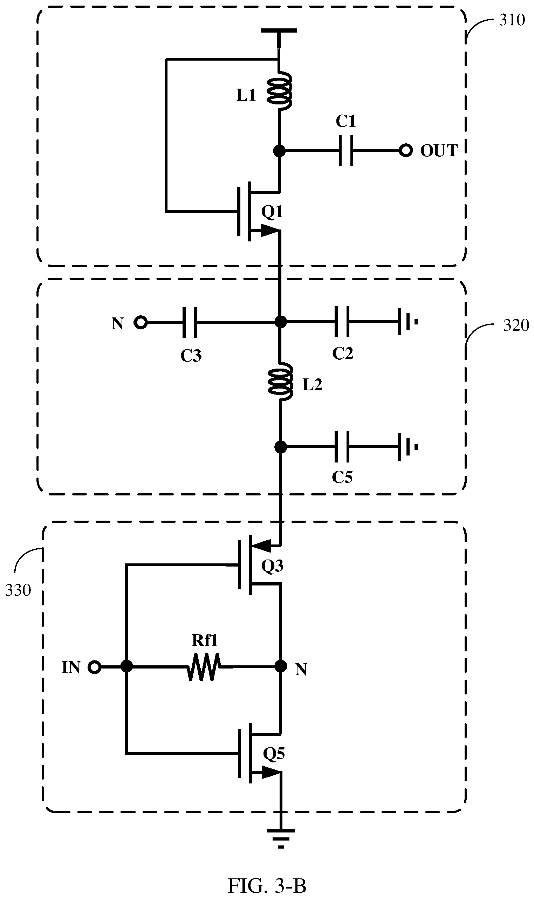

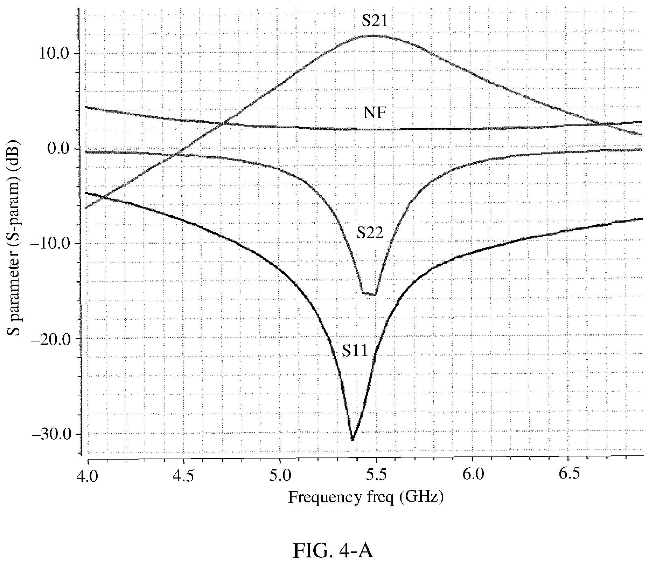

It should be noted that the amplifier is in a fully differential structure and may also operate in a single-ended mode. Implementation of a single-end structure is shown in FIG. 4-A. Functions of each part remain unchanged. A working principle is similar to that in the differential form in FIG. 3-A. FIG. 3-B is a schematic structural diagram of another possible specific circuit of a low noise amplifier according to an example of an embodiment of this application. As shown in the example of FIG. 3-B, a complementary common-source input stage includes:

The complementary common-source input stage includes a first resistor RF1, a third PMOS transistor Q3, and a fifth NMOS transistor Q5.

An inter-stage matching and coupling network includes a second capacitor C2, a third capacitor C3, a fifth capacitor C5, and a second inductor L2.

A common-gate output stage includes a first inductor L1, a first capacitor C1, and a first NMOS transistor Q1.

A gate of the fifth NMOS transistor Q5 is connected to an input end of the complementary common-source input stage. A drain of the fifth NMOS transistor Q5 is connected to the input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the input end of the complementary common-source input stage. A source of the third PMOS transistor Q3 is connected to a source of the first NMOS transistor Q1 by using the second inductor L2. The source of the third PMOS transistor Q3 is further connected to the ground by using the fifth capacitor C5.

The source of the first NMOS transistor Q1 is connected to the ground by using the second capacitor C2. The source of the first NMOS transistor Q1 is further connected to the drain of the third PMOS transistor Q3 by using the third capacitor C3

A drain of the first NMOS transistor Q1 is connected to an output end of the common-gate output stage by using the first capacitor C1.

The drain of the first NMOS transistor Q1 is connected to a power supply end by using the first inductor L1.

A gate of the first NMOS transistor Q1 is connected to the power supply end.

It may be learned that the new low noise amplifiers shown in the examples of FIG. 3-A and FIG. 3-B can implement a very good IIP3 through sharing a direct current bias current in the complementary common-source input stage and the common-gate stage. In addition, the complementary common-source input stage is used. Due to a relatively high equivalent input transconductance of the complementary common-source input stage, the circuit has very good noise performance, and overall power consumption is moderate because the current is shared. The low noise amplifier can operate in either a differential mode or a single-ended mode. An operating frequency is relatively high. All components are implemented on a chip. In this way, an area is reduced and system integration is improved. In addition, a higher IIP3 and a smaller NF are provided.

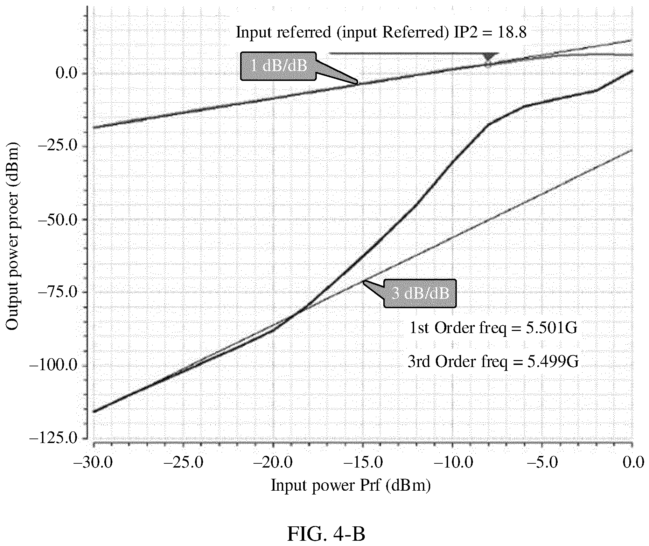

Referring to FIG. 4-A and FIG. 4-B, FIG. 4-A shows a simulation result of an S parameter and a simulation result of an NF of the amplifiers shown in FIG. 3-A and FIG. 3-B. A target operating frequency herein is 5 GHz to 6 GHz that is applicable to a WLAN communications standard. It may be learned from observation that, within 4.8 GHz to 6.2 GHz, S11 is less than -10 dB, thereby well implementing input matching. A circuit load resonates at 5.5 GHz at which a maximum gain is obtained. The maximum gain is 11.6 dB. A noise figure of the amplifier is 1.76 dB. This shows good noise performance.

FIG. 4-B shows a simulation result of an input third-order intercept point (IIP3) of the amplifiers shown in FIG. 3-A and FIG. 3-B. It may be learned from observation that a receiver can provide an IIP3 of 18.8 dBm at a resonance frequency. This shows an excellent linearity. The circuit operates within a frequency range of 4.8 GHz to 6.2 GHz, but is not limited to this frequency. The circuit may also be tuned to another frequency.

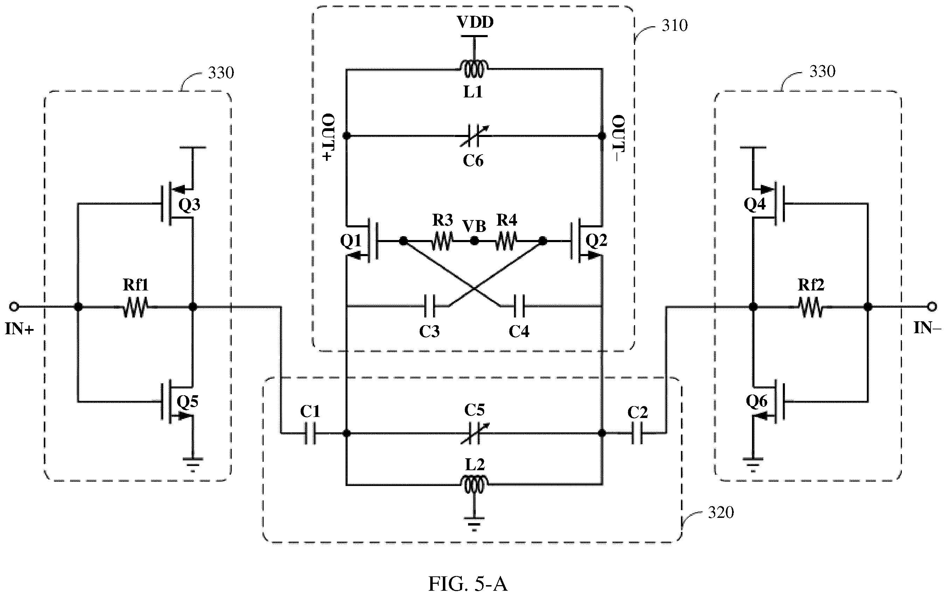

FIG. 5-A is a schematic structural diagram of another possible specific circuit of a low noise amplifier according to an example of an embodiment of this application. As shown in the example of FIG. 5-A, a complementary common-source input stage includes a first resistor RF1, a second resistor RF2, a third PMOS transistor Q3, a fourth PMOS transistor Q4, a fifth NMOS transistor Q5, and a sixth NMOS transistor Q6.

An inter-stage matching and coupling network includes a first capacitor C1, a second capacitor C2, a fifth variable capacitor C5, and a second inductor L2.

A common-gate output stage includes a first inductor L1, a third capacitor C3, a fourth capacitor C4, a first NMOS transistor Q1, a second NMOS transistor Q2, a third resistor R3, a fourth resistor R4, and a sixth variable capacitor C6.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A gate of the fourth PMOS transistor Q4 is connected to the negative input end of the complementary common-source input stage. A source of the fourth PMOS transistor Q4 is connected to a power supply end. The drain of the fourth PMOS transistor Q4 is connected to a source of the second NMOS transistor Q2 by using the second capacitor C2.

A center tap of the second inductor L2 is connected to the ground.

The second inductor L2 is connected in parallel to the fifth variable capacitor C5.

The source of the first NMOS transistor Q1 is connected to the source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a drain of the second NMOS transistor Q2 by using the sixth variable capacitor C6.

The source of the second NMOS transistor Q2 is further connected to the gate of the first NMOS transistor Q1 by using the fourth capacitor C4.

The sixth variable capacitor C6 is connected in parallel to the first inductor L1.

A center tap of the first inductor L1 is connected to a power supply end.

The drain of the first NMOS transistor Q1 is a positive output end of the common-gate output stage.

The drain of the second NMOS transistor Q2 is a negative output end of the common-gate output stage.

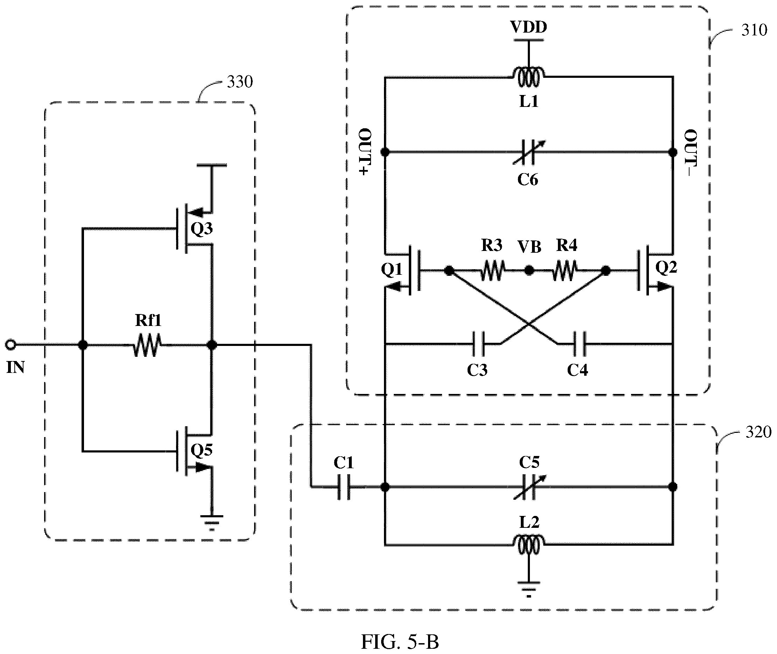

FIG. 5-B is a schematic structural diagram of another possible specific circuit of a low noise amplifier according to an example of an embodiment of this application. As shown in the example of FIG. 5-B, a complementary common-source input stage includes a first resistor RF1, a third PMOS transistor Q3, and a fifth NMOS transistor Q5.

An inter-stage matching and coupling network includes a first capacitor C1, a fifth variable capacitor C5, and a second inductor L2.

A common-gate output stage includes a first inductor L1, a third capacitor C3, a fourth capacitor C4, a first NMOS transistor Q1, a second NMOS transistor Q2, a third resistor R3, a fourth resistor R4, and a sixth variable capacitor C6.

A gate of the fifth NMOS transistor Q5 is connected to an input end of the complementary common-source input stage. A drain of the fifth NMOS transistor Q5 is connected to the input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A center tap of the second inductor L2 is connected to the ground.

The second inductor L2 is connected in parallel to the fifth variable capacitor C5.

The source of the first NMOS transistor Q1 is connected to a source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a drain of the second NMOS transistor Q2 by using the sixth variable capacitor C6.

The source of the second NMOS transistor Q2 is further connected to the gate of the first NMOS transistor Q1 by using the fourth capacitor C4.

The sixth variable capacitor C6 is connected in parallel to the first inductor L1.

A center tap of the first inductor L1 is connected to a power supply end.

The drain of the first NMOS transistor Q1 is a positive output end of the common-gate output stage.

The drain of the second NMOS transistor Q2 is a negative output end of the common-gate output stage.

FIG. 5-A shows a fully differential form. FIG. 5-B shows a single-ended input and differential output form with a balun function. The complementary common-source input stage includes the NMOS, the PMOS, and the like. A gate bias may be provided by using a feedback resistor with a large resistance value, so that all the MOS transistors operate in a saturation region. The sources of the PMOSs in the two differential paths are connected to a VDD. An alternating current signal is output from a drain node and is coupled to the next-stage passive coupling network by using the capacitor C3/C4, which is also the source of the NMOS transistor of the common-gate input stage. The common-gate stage uses a capacitive cross-coupling input manner, and an equivalent transconductance of the common-gate transistor may be increased at the same current bias, thereby improving a gain and reducing a noise contribution of the common-gate transistor. The inter-stage passive matching network includes an LC resonant network and the coupling capacitor C3/C4. An inductor in the resonant network is a differential inductor. A center tap of the inductor is connected to the ground. The resonant network implements a function of alternating current isolation, so that most of the alternating current signals flow into the source of the common-gate input stage and are finally amplified at the drain of the common-gate transistor. Similarly, a drain load is constructed by using the LC resonant network, and resonates at a signal operating frequency and provides a specific gain. In addition, a signal is coupled to a next-stage frequency mixer to a greatest extent. The circuit operates in a narrowband mode, and needs an additional input/output matching network. The matching network is not shown in the figure.

It can be learned from the foregoing analysis that the complementary common-source input stage may partially cancel a second-order nonlinearity and improve a third-order nonlinearity. A size ratio of the PMOS transistor and the NMOS transistor is adjusted, to achieve best second-order nonlinearity cancellation effects and reduce the third-order nonlinearity of the circuit. In this way, the entire circuit can implement a relatively good IIP3.

It may be learned that the new low noise amplifiers shown in the examples of FIG. 5-A and FIG. 5-B can implement a very good IIP3. The complementary common-source input stage is used. Due to a relatively high equivalent input transconductance of the complementary common-source input stage, the circuit has very good noise performance, and overall power consumption is moderate because the current is shared. The low noise amplifier can operate in either a differential mode or a single-ended mode, and can implement a higher IIP3 and better noise performance without being tuned. In addition, the operating frequency is higher, and all components are implemented on a chip, to reduce an area and improve system integration, thereby providing a higher IIP3 and a smaller NF.

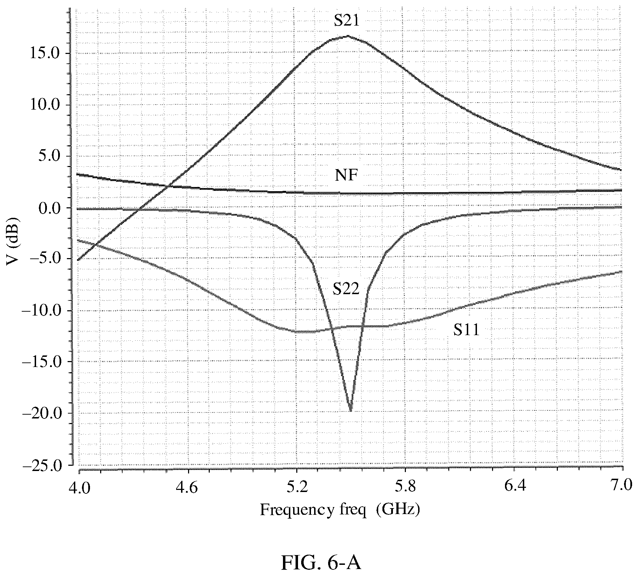

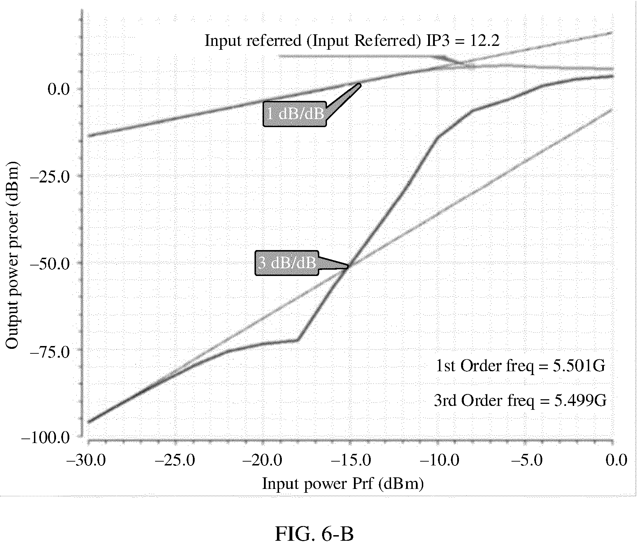

Referring to FIG. 6-A and FIG. 6-B, FIG. 6-A shows a simulation result of an S parameter and a simulation result of an NF of the amplifier shown in FIG. 5-A. A target operating frequency herein is 5 GHz to 6 GHz that is applicable to a WLAN communications standard. It may be learned from observation that, within 4.8 GHz to 6.2 GHz, S11 is less than -10 dB, thereby well implementing input matching. A circuit load resonates at 5.5 GHz at which a maximum gain is obtained. The maximum gain is 16.3 dB that is 5 dB greater than that in Embodiment 1. A noise figure of the amplifier is 1.22 dB. This shows excellent noise performance.

FIG. 6-B shows a simulation result of an input third-order intercept point (IIP3) of the amplifier shown in FIG. 5-A. It may be learned from observation that a receiver can provide an IIP3 of 11.2 dBm at a resonance frequency. This shows an excellent linearity and proves the functions of the present invention. A circuit operates within a frequency range of 4.9 GHz to 6.1 GHz, but is not limited to this frequency. The circuit may also be tuned to another frequency.

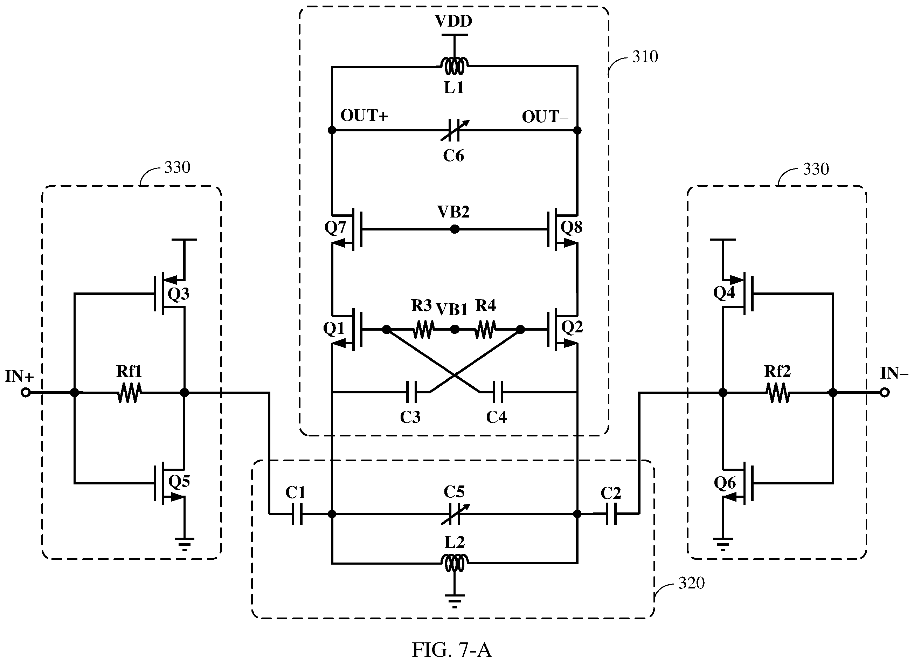

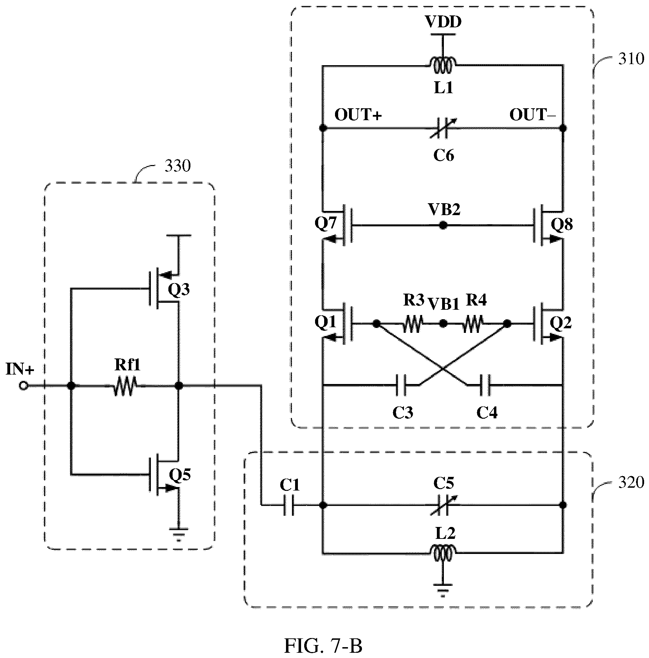

In FIG. 5-A, the common-gate stage may be changed to a form of a dual common-gate stage, to further improve isolation between an input end and an output end and further reduce leakage of an LO to an input end. A specific circuit is shown in FIG. 7-A and FIG. 7-B. In addition, functions of other modules remain unchanged. A working principle is similar to that in FIG. 5-A.

FIG. 7-A is a schematic structural diagram of another possible specific circuit of a low noise amplifier according to an example of an embodiment of this application. As shown in the example of FIG. 7-A, a complementary common-source input stage includes a first resistor RF1, a second resistor RF2, a third PMOS transistor Q3, a fourth PMOS transistor Q4, a fifth NMOS transistor Q5, and a sixth NMOS transistor Q6.

An inter-stage matching and coupling network includes a first capacitor C1, a second capacitor C2, a fifth variable capacitor C5, and a second inductor L2.

A common-gate output stage includes a first inductor L1, a third capacitor C3, a fourth capacitor C4, a first NMOS transistor Q1, a second NMOS transistor Q2, a third resistor R3, a fourth resistor R4, a sixth variable capacitor C6, a seventh NMOS transistor Q7, and an eighth NMOS transistor Q8.

A gate of the fifth NMOS transistor Q5 is connected to a positive input end of the complementary common-source input stage. A drain of the fifth NMOS transistor Q5 is connected to the positive input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the sixth NMOS transistor Q6 is connected to a negative input end of the complementary common-source input stage. A drain of the sixth NMOS transistor Q6 is connected to the negative input end of the complementary common-source input stage by using the second resistor RF2. A source of the sixth NMOS transistor Q6 is connected to the ground. The drain of the sixth NMOS transistor Q6 is further connected to a drain of the fourth PMOS transistor Q4.

A gate of the third PMOS transistor Q3 is connected to the positive input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A gate of the fourth PMOS transistor Q4 is connected to the negative input end of the complementary common-source input stage. A source of the fourth PMOS transistor Q4 is connected to a power supply end. The drain of the fourth PMOS transistor Q4 is connected to a source of the second NMOS transistor Q2 by using the second capacitor C2.

A center tap of the second inductor L2 is connected to the ground.

The second inductor L2 is connected in parallel to the fifth variable capacitor C5.

The source of the first NMOS transistor Q1 is connected to the source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a source of the seventh NMOS transistor Q7.

The source of the second NMOS transistor Q2 is further connected to the gate of the first NMOS transistor Q1 by using the fourth capacitor C4.

A drain of the second NMOS transistor Q2 is connected to a source of the eighth NMOS transistor Q8.

A drain of the seventh NMOS transistor Q7 is connected to a drain of the eighth NMOS transistor Q8 by using the sixth variable capacitor C6.

A gate of the seventh NMOS transistor Q7 is connected to a gate of the eighth NMOS transistor Q8.

The sixth variable capacitor C6 is connected in parallel to the first inductor L1.

A center tap of the first inductor L1 is connected to a power supply end.

The drain of the seventh NMOS transistor Q7 is a positive output end of the common-gate output stage.

The drain of the eighth NMOS transistor Q8 is a negative output end of the common-gate output stage.

FIG. 7-B is a schematic structural diagram of another possible specific circuit of a low noise amplifier according to an example of an embodiment of this application. As shown in the example of FIG. 7-B, a complementary common-source input stage includes a first resistor RF1, a third PMOS transistor Q3, and a fifth NMOS transistor Q5.

An inter-stage matching and coupling network includes a first capacitor C1, a third capacitor C3, a fourth capacitor C4, a fifth variable capacitor C5, and a second inductor L2.

A common-gate output stage may specifically include a first inductor L1, a first NMOS transistor Q1, a second NMOS transistor Q2, a third resistor R3, a fourth resistor R4, a sixth variable capacitor C6, a seventh NMOS transistor Q7, and an eighth NMOS transistor Q8.

A gate of the fifth NMOS transistor Q5 is connected to an input end of the complementary common-source input stage. A drain of the fifth NMOS transistor Q5 is connected to the input end of the complementary common-source input stage by using the first resistor RF1. A source of the fifth NMOS transistor Q5 is connected to the ground. The drain of the fifth NMOS transistor Q5 is further connected to a drain of the third PMOS transistor Q3.

A gate of the third PMOS transistor Q3 is connected to the input end of the complementary common-source input stage. A source of the third PMOS transistor Q3 is connected to a power supply end. The drain of the third PMOS transistor Q3 is connected to a source of the first NMOS transistor Q1 by using the first capacitor C1.

A center tap of the second inductor L2 is connected to the ground.

The second inductor L2 is connected in parallel to the fifth variable capacitor C5.

The source of the first NMOS transistor Q1 is connected to a source of the second NMOS transistor Q2 by using the fifth variable capacitor C5. The source of the first NMOS transistor Q1 is further connected to a gate of the second NMOS transistor Q2 by using the third capacitor C3.

A gate of the first NMOS transistor Q1 is further connected to the gate of the second NMOS transistor Q2 by using the third resistor and the fourth resistor.

A drain of the first NMOS transistor Q1 is connected to a source of the seventh NMOS transistor Q7.

The source of the second NMOS transistor Q2 is further connected to the gate of the first NMOS transistor Q1 by using the fourth capacitor C4.

A drain of the second NMOS transistor Q2 is connected to a source of the eighth NMOS transistor Q8.

A drain of the seventh NMOS transistor Q7 is connected to a drain of the eighth NMOS transistor Q8 by using the sixth variable capacitor C6.

A gate of the seventh NMOS transistor Q7 is connected to a gate of the eighth NMOS transistor Q8.

The sixth variable capacitor C6 is connected in parallel to the first inductor L1.

A center tap of the first inductor L1 is connected to a power supply end.

The drain of the seventh NMOS transistor Q7 is a positive output end of the common-gate output stage.

The drain of the eighth NMOS transistor Q8 is a negative output end of the common-gate output stage.

FIG. 5-B and FIG. 7-B show examples of balun-type (Balanced to Unbalanced) low noise amplifiers. The complementary common-source input stage is in a single-ended form, and the inter-stage matching network and the common-gate output stage are in a differential form. The complementary common-source input stage includes the NMOS transistor, the PMOS transistor, and the like. A gate bias may be provided by using a feedback resistor with a large resistance value, so that all the MOS transistors operate in a saturation region. An alternating current signal is output from a drain node and is coupled to the next-stage passive coupling network by using the capacitor C3/C4, which is also the source of the NMOS transistor of the common-gate input stage. The common-gate stage uses a capacitive cross-coupling input manner, and an equivalent transconductance of the common-gate transistor may be increased at the same current bias, thereby improving a gain and reducing a noise contribution of the common-gate transistor.

The inter-stage passive matching network includes an LC resonant network and the coupling capacitor C3/C4. An inductor in the resonant network is a differential inductor. A center tap of the inductor is connected to the ground. The resonant network implements a function of alternating current isolation, so that most of the alternating current signals flow into the source of the common-gate input stage and are finally amplified at the drain of the common-gate transistor. The inter-stage passive matching network and a capacitive cross-coupling common-gate stage further have a balun function. An input signal of the single-ended common-gate stage is converted to a differential signal for output. Similarly, a drain load is constructed by using the LC resonant network, and resonates at a signal operating frequency and provides a specific gain. In addition, a signal is coupled to a next-stage frequency mixer to a greatest extent. The circuit operates in a narrowband mode, and needs an additional input/output matching network. The matching network is not shown in the figure. In comparison with FIG. 5-A and FIG. 5-B, FIG. 7-A and FIG. 8-A both show forms of a dual common-gate stage, to further improve isolation between an input end and an output end and further reduce leakage of an LO to an input end.

Different from FIG. 3-A and FIG. 5-A, although the second-order nonlinearity of the complementary common-source input stage is partially cancelled, the third-order nonlinearity of the complementary common-source input stage is converted by a next-stage balun function module to a differential signal and output to an output end. In this case, cancellation is not well implemented. Therefore, an IIP3 of the circuit is not as good as that in the two figures. However, noise performance is still good because the complementary common-source input stage has a high equivalent transconductance.

It may be learned that, in the examples of FIG. 7-A and FIG. 7-B, the new low noise amplifier can implement very good noise performance. The low noise amplifier has a balun function, and implements single-ended input and differential output. No off-chip balun is required. In this case, costs are reduced and integration is improved. The common-gate stage is a dual common-gate structure. The balun function can be implemented on the basis of maintaining low noise performance, to avoid use of an off-chip balun, thereby reducing costs and improving integration.

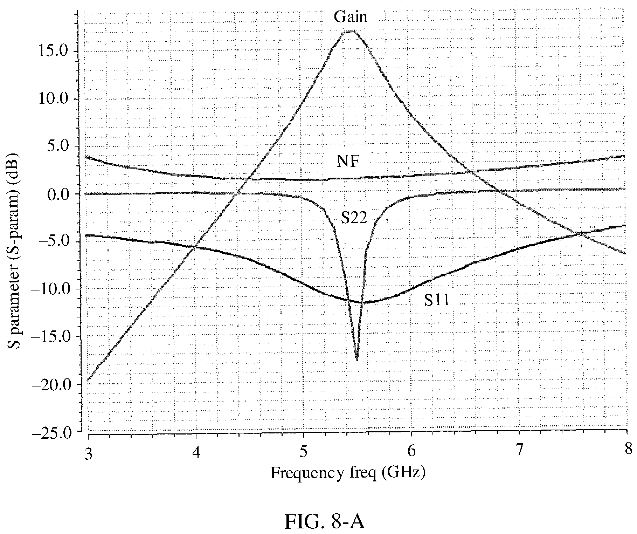

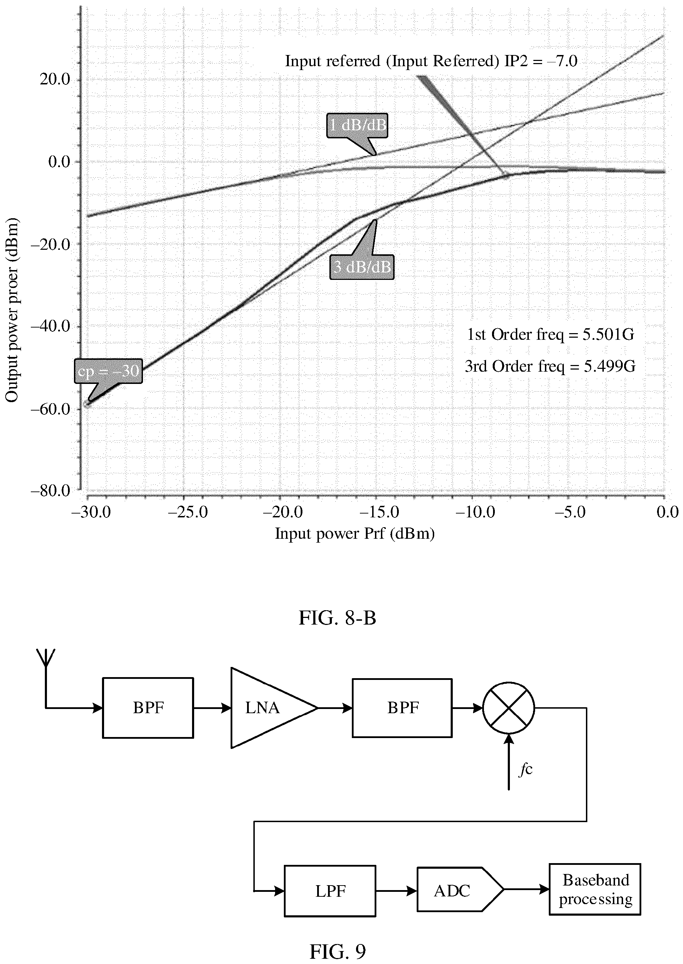

Referring to FIG. 8-A and FIG. 8-B, FIG. 8-A shows a simulation result of an S parameter and a simulation result of an NF of the circuit shown in the example of FIG. 7-A. A target operating frequency herein is 5 GHz to 6 GHz that is applicable to a WLAN communications standard. It may be learned from observation that, within 5.0 GHz to 6.1 GHz, S11 is less than -10 dB, thereby implementing good input matching. A circuit load resonates at 5.5 GHz at which a maximum gain is obtained. The maximum gain is 16.8 dB that is 5 dB greater than that in FIG. 1-B-1 and FIG. 1-B-2. A noise figure of the amplifier is 1.34 dB. This shows excellent noise performance.

FIG. 8-B shows a simulation result of an input third-order intercept point (IIP3) of the circuit in the example of FIG. 7-A. It may be learned from observation that a receiver can provide an IIP3 of -7.0 dBm at a resonance frequency. The circuit operates within a frequency range of 5.0 GHz to 6.1 GHz, but is not limited to this frequency. The circuit may also be tuned to another frequency.

In comparison with the circuits shown in FIG. 3-A and FIG. 5-A, the circuit shown in FIG. 7-A has the least power consumption because only a single-ended input common-source stage is required.

An embodiment of this application further provides a receiver. The receiver may include any low noise amplifier provided in the examples of the embodiments of this application. A specific structure of the receiver may be shown, for example, in an example of FIG. 9. Specifically, the receiver may include a first band-pass filter BPF, a low noise amplifier, a second band-pass filter BPF, a frequency mixer, a low-pass filter, an analog-to-digital converter ADC, and the like.

An input end of the first band-pass filter is connected to an antenna. An output end of the first band-pass filter is connected to an input end of the low noise amplifier. An output end of the low noise amplifier is connected to an input end of the second band-pass filter. An output end of the second band-pass filter is connected to an input end of the frequency mixer. Herein, f_{c} represents a frequency mixing signal. An output end of the frequency mixer is connected to an input end of the low-pass filter. An output end of the low-pass filter is connected to an input end of the analog-to-digital converter. Baseband processing is performed on a digital signal output from an output end of the analog-to-digital converter.

In general, in some architectures of the new receiver provided in this embodiment of this application, input matching on a relatively high frequency (Multi-GHz) may be implemented through introducing an inductor. The structure is simple. In addition to the inductor, a structure of a primary signal pathway and a structure of an auxiliary signal pathway are the same. A first stage is a complementary transconductance amplifier sharing a DC bias current, so that overall power consumption is not large. The receiver may operate in a current mode and has a relatively high linearity. The receiver system provided in this application uses a noise cancellation technology. Thermal noise of an input series inductor can be cancelled by using the auxiliary path, so that a circuit has very good noise performance.

A system of the new low noise amplifier provided in this application mainly includes three parts: a complementary common-source input stage, an inter-stage matching and coupling network, and a common-gate output stage. All components are implemented on a chip and can be configured into a plurality of structures. In addition, the system may operate in a narrowband mode, or may be configured with a broadband mode. This is jointly determined by a specific input/output matching network and an inter-stage coupling network.

It is found through test that the receiver system provided in this application keeps a high linearity and low noise, and reduces leakage of a Lo signal to the antenna. The low noise amplifier system and the receiver system provided in this application are not only applicable to a low frequency (<3 GHz) but also applicable to a relatively high frequency (>3 GHz).

In the low noise amplifier system provided in this application, low noise performance is particularly apparent. In some examples of the low noise amplifier system, a high IIP3 can be further implemented based on a low noise figure.

Some instances of the low noise amplifier system may implement a function of an internally integrated balun. The receiver and the low noise amplifier are applicable to a 5 GHz WLAN and 5G-NR, but are not limited to these frequency bands and standards. The receiver and the low noise amplifier are also applicable to other frequency bands and standards.

In the foregoing embodiments, the description of each embodiment may have respective focuses. Therefore, for a part that is not described in detail in an embodiment, refer to related descriptions in other embodiments.

In the several embodiments provided in this application, it should be understood that the disclosed apparatuses may also be implemented in other manners. For example, the described apparatus embodiments are merely examples. For example, unit division is merely logical function division and there may be another division in actual implementation. For example, a plurality of units or components may be combined or integrated into another system, or some features may be ignored or not performed. In addition, the displayed or discussed mutual indirect couplings or direct couplings or communication connections may be implemented by using some interfaces. The indirect couplings or communication connections between the apparatuses or units may be implemented in electronic or another form.

The units described as separate parts may or may not be physically separate, and parts displayed as units may or may not be physical units, that is, may be located in one position, or may be distributed on a plurality of devices. Some or all of the units may be selected based on actual needs to achieve the objectives of the solutions of the embodiments.

## Claims

1. A receiver, wherein the receiver comprises: a primary signal pathway, an auxiliary signal pathway, a combiner circuit, and an intermediate frequency amplifier circuit, wherein
the primary signal pathway comprises a gate series inductor L1, a first common-source amplifier circuit, and a frequency mixing circuit, an input end of the primary signal pathway is connected to an input end of the first common-source amplifier circuit by using the gate series inductor, an output end of the first common-source amplifier circuit is connected to an input end of the frequency mixing circuit, an output end of the frequency mixing circuit is connected to a first input end of the combiner circuit, an output end of the combiner circuit is connected to an input end of the intermediate frequency amplifier circuit, and the gate series inductor L1 is an on-chip inductor; and
the auxiliary signal pathway comprises a second common-source amplifier circuit and a frequency mixing and phase shift circuit, an input end of the auxiliary signal pathway is connected to an input end of the second common-source amplifier circuit, an output end of the second common-source amplifier circuit is connected to an input end of the frequency mixing and phase shift circuit, and an output end of the frequency mixing and phase shift circuit is connected to a second input end of the combiner circuit.

2. The receiver according to claim 1, wherein
the first common-source amplifier circuit comprises:
a first PMOS transistor Q1, a second NMOS transistor Q2, a first resistor R1, and a first capacitor C1, wherein
a source of the first PMOS transistor Q1 is connected to a power supply end, a gate of the first PMOS transistor Q1 is connected to a gate of the second NMOS transistor Q2 and the gate of the first PMOS transistor Q1 is further connected to a drain of the first PMOS transistor Q1 by using the first resistor R1, the drain of the first PMOS transistor Q1 is connected to a drain of the second NMOS transistor Q2 and the drain of the first PMOS transistor Q1 is further connected to the output end of the first common-source amplifier circuit by using the first capacitor C1, and the gate of the first PMOS transistor Q1 is the input end of the first common-source amplifier circuit; and
a source of the second NMOS transistor Q2 is connected to the ground, and the gate of the second NMOS transistor Q2 is connected to the drain of the second NMOS transistor Q2 by using the first resistor R1.

3. The receiver according to claim 1 or 2, wherein the receiver further comprises a seventh capacitor C7, wherein
the second common-source amplifier circuit comprises:
a third PMOS transistor Q3, a fourth NMOS transistor Q4, a second resistor R2, and a second capacitor C2;
a source of the third PMOS transistor Q3 is connected to a power supply end, a gate of the third PMOS transistor Q3 is connected to a gate of the fourth NMOS transistor Q4 and the gate of the third PMOS transistor Q3 is further connected to a drain of the third PMOS transistor Q3 by using the second resistor R2, the drain of the third PMOS transistor Q3 is connected to a drain of the fourth NMOS transistor Q4 and the drain of the third PMOS transistor Q3 is further connected to the output end of the second common-source amplifier circuit by using the second capacitor C2, and the gate of the third PMOS transistor Q2 is the input end of the second common-source amplifier circuit; and
a source of the fourth NMOS transistor Q4 is connected to the ground, the gate of the fourth NMOS transistor Q4 is connected to the drain of the fourth NMOS transistor Q4 by using the second resistor R2,
the gate of the fourth NMOS transistor Q4 is further connected to the gate of the third PMOS transistor Q3 by using a first inductor L1, and
the gate of the fourth NMOS transistor Q4 is further connected to an input end of the receiver by using the seventh capacitor C7.

4. The receiver according to any one of claims 1 to 3, wherein the frequency mixing circuit comprises a fifth NMOS transistor Q5, a sixth NMOS transistor Q6, a seventh NMOS transistor Q7, and an eighth NMOS transistor Q8; and
the intermediate frequency amplifier circuit comprises a first intermediate frequency amplifier IF-AMP 1, a second intermediate frequency amplifier IF-AMP 2, a third variable resistor R3, a third variable capacitor C3, a fourth variable resistor R4, a fourth variable capacitor C4, a fifth variable resistor R5, a fifth variable capacitor C5, a sixth variable resistor R6, and a sixth variable capacitor C6, wherein
a gate of the fifth NMOS transistor Q5 is connected to an output end of a first local oscillator signal Lo1,
a drain of the fifth NMOS transistor Q5 is connected to the output end of the first common-source amplifier circuit, a source of the fifth NMOS transistor Q5 is connected to a positive input end of the first intermediate frequency amplifier IF-AMP 1, and the drain of the fifth NMOS transistor Q5 is further separately connected to a drain of the sixth NMOS transistor Q6, a drain of the seventh NMOS transistor Q7, and a drain of the eighth NMOS transistor Q8;
a gate of the sixth NMOS transistor Q6 is connected to an output end of a second local oscillator signal Lo2, and
a source of the sixth NMOS transistor Q6 is connected to a negative input end of the first intermediate frequency amplifier IF-AMP 1;
a gate of the seventh NMOS transistor Q7 is connected to an output end of a third local oscillator signal Lo3, and
a source of the seventh NMOS transistor Q7 is connected to a positive input end of the second intermediate frequency amplifier IF-AMP 2;
a gate of the eighth NMOS transistor Q8 is connected to the output end of the second local oscillator signal Lo2, and
a source of the eighth NMOS transistor Q8 is connected to a negative input end of the second intermediate frequency amplifier IF-AMP 2;
the third variable resistor R3 is connected in parallel to the third variable capacitor C3, and
the positive input end of the first intermediate frequency amplifier IF-AMP 1 is connected to a negative output end of the first intermediate frequency amplifier IF-AMP 1 by using the third variable capacitor C3;
the fourth variable resistor R4 is connected in parallel to the fourth variable capacitor C4, and
the negative input end of the first intermediate frequency amplifier IF-AMP 1 is connected to a positive output end of the first intermediate frequency amplifier IF-AMP 1 by using the fourth variable capacitor C4;
the fifth variable resistor R5 is connected in parallel to the fifth variable capacitor C5, and
the positive input end of the second intermediate frequency amplifier IF-AMP 2 is connected to a negative output end of the second intermediate frequency amplifier IF-AMP 2 by using the fifth variable capacitor C5; and
the sixth variable resistor R6 is connected in parallel to the sixth variable capacitor C6, and
the negative input end of the second intermediate frequency amplifier IF-AMP 2 is connected to a positive output end of the second intermediate frequency amplifier IF-AMP 2 by using the fourth variable capacitor C6.

5. The receiver according to claim 4, wherein the frequency mixing and phase shift circuit comprises:
a ninth NMOS transistor Q9, a tenth NMOS transistor Q10, an eleventh NMOS transistor Q11, and a twelfth NMOS transistor Q12, wherein
a gate of the ninth NMOS transistor Q9 is connected to the output end of the first local oscillator signal Lo1,
a drain of the ninth NMOS transistor Q9 is connected to the output end of the second common-source amplifier circuit, a source of the ninth NMOS transistor Q9 is connected to the positive input end of the first intermediate frequency amplifier IF-AMP 1, and the drain of the ninth NMOS transistor Q9 is further separately connected to a drain of the tenth NMOS transistor Q10, a drain of the eleventh NMOS transistor Q11, and a drain of the twelfth NMOS transistor Q12;
a gate of the tenth NMOS transistor Q10 is connected to the output end of the second local oscillator signal Lo2, and
a source of the tenth NMOS transistor Q10 is connected to the negative input end of the first intermediate frequency amplifier IF-AMP 1;
a gate of the eleventh NMOS transistor Q11 is connected to the output end of the third local oscillator signal Lo3, and
a source of the eleventh NMOS transistor Q11 is connected to the positive input end of the second intermediate frequency amplifier IF-AMP 2; and
a gate of the twelfth NMOS transistor Q12 is connected to an output end of a fourth local oscillator signal Lo4, and
a source of the twelfth NMOS transistor Q12 is connected to the negative input end of the second intermediate frequency amplifier IF-AMP 2.

6. A low noise amplifier, wherein the low noise amplifier comprises a complementary common-source input stage, an inter-stage matching and coupling network, and a common-gate output stage, wherein the complementary common-source input stage and the common-gate output stage are coupled by using the inter-stage matching and coupling network, and the complementary common-source input stage, the inter-stage matching and coupling network, and the common-gate output stage all use fully integrated on-chip elements.

7. The amplifier according to claim 6, wherein
the complementary common-source input stage comprises:
a first resistor RF1, a second resistor RF2, a third PMOS transistor Q3, a fourth PMOS transistor Q4, a fifth NMOS transistor Q5, and a sixth NMOS transistor Q6;
the inter-stage matching and coupling network comprises a second capacitor C2, a third capacitor C3, a fourth capacitor C4, a fifth capacitor C5, and a second inductor L2; and
the common-gate output stage comprises a first inductor L1, a first capacitor C1, a first NMOS transistor Q1, and a second NMOS transistor Q2, wherein
a gate of the fifth NMOS transistor Q5 is connected to a positive input end of the complementary common-source input stage, a drain of the fifth NMOS transistor Q5 is connected to the positive input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the sixth NMOS transistor Q6 is connected to a negative input end of the complementary common-source input stage, a drain of the sixth NMOS transistor Q6 is connected to the negative input end of the complementary common-source input stage by using the second resistor RF2, a source of the sixth NMOS transistor Q6 is connected to the ground, and the drain of the sixth NMOS transistor Q6 is further connected to a drain of the fourth PMOS transistor Q4;
a gate of the third PMOS transistor Q3 is connected to the positive input end of the complementary common-source input stage, and a source of the third PMOS transistor Q3 is connected to a source of the fourth PMOS transistor Q4;
a gate of the fourth PMOS transistor Q4 is connected to the negative input end of the complementary common-source input stage;
a center tap of the second inductor L2 is connected to the source of the third PMOS transistor Q3 and the source of the fourth PMOS transistor Q4, and the center tap of the second inductor L2 is further connected to the ground by using the fifth capacitor C5;
the second inductor L2 is connected in parallel to the second capacitor C2; and
a source of the first NMOS transistor Q1 is connected to a source of the second NMOS transistor Q2 by using the second capacitor C2, the source of the first NMOS transistor Q1 is further connected to the drain of the third PMOS transistor Q3 by using the third capacitor C3, the source of the second NMOS transistor Q2 is further connected to the drain of the fourth PMOS transistor Q4 by using the fourth capacitor C4,
a drain of the first NMOS transistor Q1 is connected to a drain of the second NMOS transistor Q2 by using the first capacitor C1,
the first capacitor C1 is connected in parallel to the first inductor L1,
a center tap of the first inductor L1 is connected to a power supply end,
a gate of the first NMOS transistor Q1 and a gate of the second NMOS transistor Q2 are connected to the power supply end,
the drain of the first NMOS transistor Q1 is a positive output end of the common-gate output stage, and
the drain of the second NMOS transistor Q2 is a negative output end of the common-gate output stage.

8. The amplifier according to claim 6, wherein
the complementary common-source input stage comprises a first resistor RF1, a third PMOS transistor Q3, and a fifth NMOS transistor Q5;
the inter-stage matching and coupling network comprises a second capacitor C2, a third capacitor C3, a fifth capacitor C5, and a second inductor L2; and
the common-gate output stage comprises a first inductor L1, a first capacitor C1, and a first NMOS transistor Q1, wherein
a gate of the fifth NMOS transistor Q5 is connected to an input end of the complementary common-source input stage, a drain of the fifth NMOS transistor Q5 is connected to the input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the third PMOS transistor Q3 is connected to the input end of the complementary common-source input stage, a source of the third PMOS transistor Q3 is connected to a source of the first NMOS transistor Q1 by using the second inductor L2, and the source of the third PMOS transistor Q3 is further connected to the ground by using the fifth capacitor C5; and
the source of the first NMOS transistor Q1 is connected to the ground by using the second capacitor C2, the source of the first NMOS transistor Q1 is further connected to the drain of the third PMOS transistor Q3 by using the third capacitor C3,
a drain of the first NMOS transistor Q1 is connected to an output end of the common-gate output stage by using the first capacitor C1,
the drain of the first NMOS transistor Q1 is connected to a power supply end by using the first inductor L1, and a gate of the first NMOS transistor Q1 is connected to the power supply end.

9. The amplifier according to claim 6, wherein
the complementary common-source input stage comprises:
a first resistor RF1, a second resistor RF2, a third PMOS transistor Q3, a fourth PMOS transistor Q4, a fifth NMOS transistor Q5, and a sixth NMOS transistor Q6;
the inter-stage matching and coupling network comprises a first capacitor C1, a second capacitor C2, a fifth variable capacitor C5, and a second inductor L2; and
the common-gate output stage comprises:
a first inductor L1, a third capacitor C3, a fourth capacitor C4, a first NMOS transistor Q1, a second NMOS transistor Q2, a third resistor R3, a fourth resistor R4, and a sixth variable capacitor C6, wherein
a gate of the fifth NMOS transistor Q5 is connected to a positive input end of the complementary common-source input stage, a drain of the fifth NMOS transistor Q5 is connected to the positive input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the sixth NMOS transistor Q6 is connected to a negative input end of the complementary common-source input stage, a drain of the sixth NMOS transistor Q6 is connected to the negative input end of the complementary common-source input stage by using the second resistor RF2, a source of the sixth NMOS transistor Q6 is connected to the ground, and the drain of the sixth NMOS transistor Q6 is further connected to a drain of the fourth PMOS transistor Q4;
a gate of the third PMOS transistor Q3 is connected to the positive input end of the complementary common-source input stage, a source of the third PMOS transistor Q3 is connected to a power supply end, and the drain of the third PMOS transistor Q3 is connected to a source of the first NMOS transistor Q1 by using the first capacitor C1;
a gate of the fourth PMOS transistor Q4 is connected to the negative input end of the complementary common-source input stage, a source of the fourth PMOS transistor Q4 is connected to a power supply end, and the drain of the fourth PMOS transistor Q4 is connected to a source of the second NMOS transistor Q2 by using the second capacitor C2;
a center tap of the second inductor L2 is connected to the ground, and
the second inductor L2 is connected in parallel to the fifth variable capacitor C5;
the source of the first NMOS transistor Q1 is connected to the source of the second NMOS transistor Q2 by using the fifth variable capacitor C5, the source of the first NMOS transistor Q1 is further connected to a gate of the second NMOS transistor Q2 by using the third capacitor C3, and
a gate of the first NMOS transistor Q1 is further connected to the gate of the second NMOS transistor Q2 by using the third resistor and the fourth resistor; and
a drain of the first NMOS transistor Q1 is connected to a drain of the second NMOS transistor Q2 by using the sixth variable capacitor C6,
the source of the second NMOS transistor Q2 is further connected to the gate of the first NMOS transistor Q1 by using the fourth capacitor C4,
the sixth variable capacitor C6 is connected in parallel to the first inductor L1,
a center tap of the first inductor L1 is connected to a power supply end,
the drain of the first NMOS transistor Q1 is a positive output end of the common-gate output stage, and
the drain of the second NMOS transistor Q2 is a negative output end of the common-gate output stage.

10. The amplifier according to claim 6, wherein
the complementary common-source input stage comprises a first resistor RF1, a third PMOS transistor Q3, and a fifth NMOS transistor Q5;
the inter-stage matching and coupling network comprises a first capacitor C1, a second capacitor C2, a fifth variable capacitor C5, and a second inductor L2; and
the common-gate output stage comprises:
a first inductor L1, a third capacitor C3, a fourth capacitor C4, a first NMOS transistor Q1, a second NMOS transistor Q2, a third resistor R3, a fourth resistor R4, and a sixth variable capacitor C6, wherein
a gate of the fifth NMOS transistor Q5 is connected to an input end of the complementary common-source input stage, a drain of the fifth NMOS transistor Q5 is connected to the input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the third PMOS transistor Q3 is connected to the input end of the complementary common-source input stage, a source of the third PMOS transistor Q3 is connected to a power supply end, and the drain of the third PMOS transistor Q3 is connected to a source of the first NMOS transistor Q1 by using the first capacitor C1;
a center tap of the second inductor L2 is connected to the ground, and
the second inductor L2 is connected in parallel to the fifth variable capacitor C5;
the source of the first NMOS transistor Q1 is connected to a source of the second NMOS transistor Q2 by using the fifth variable capacitor C5, the source of the first NMOS transistor Q1 is further connected to a gate of the second NMOS transistor Q2 by using the third capacitor C3, and
a gate of the first NMOS transistor Q1 is further connected to the gate of the second NMOS transistor Q2 by using the third resistor and the fourth resistor; and
a drain of the first NMOS transistor Q1 is connected to a drain of the second NMOS transistor Q2 by using the sixth variable capacitor C6,
the source of the second NMOS transistor Q2 is further connected to the gate of the first NMOS transistor Q1 by using the fourth capacitor C4,
the sixth variable capacitor C6 is connected in parallel to the first inductor L1,
a center tap of the first inductor L1 is connected to a power supply end,
the drain of the first NMOS transistor Q1 is a positive output end of the common-gate output stage, and
the drain of the second NMOS transistor Q2 is a negative output end of the common-gate output stage.

11. The amplifier according to claim 6, wherein
the complementary common-source input stage comprises:
a first resistor RF1, a second resistor RF2, a third PMOS transistor Q3, a fourth PMOS transistor Q4, a fifth NMOS transistor Q5, and a sixth NMOS transistor Q6;
the inter-stage matching and coupling network comprises a first capacitor C1, a second capacitor C2, a fifth variable capacitor C5, and a second inductor L2; and
the common-gate output stage comprises:
a first inductor L1, a third capacitor C3, a fourth capacitor C4, a first NMOS transistor Q1, a second NMOS transistor Q2, a third resistor R3, a fourth resistor R4, a sixth variable capacitor C6, a seventh NMOS transistor Q7, and an eighth NMOS transistor Q8, wherein
a gate of the fifth NMOS transistor Q5 is connected to a positive input end of the complementary common-source input stage, a drain of the fifth NMOS transistor Q5 is connected to the positive input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the sixth NMOS transistor Q6 is connected to a negative input end of the complementary common-source input stage, a drain of the sixth NMOS transistor Q6 is connected to the negative input end of the complementary common-source input stage by using the second resistor RF2, a source of the sixth NMOS transistor Q6 is connected to the ground, and the drain of the sixth NMOS transistor Q6 is further connected to a drain of the fourth PMOS transistor Q4;
a gate of the third PMOS transistor Q3 is connected to the positive input end of the complementary common-source input stage, a source of the third PMOS transistor Q3 is connected to a power supply end, and the drain of the third PMOS transistor Q3 is connected to a source of the first NMOS transistor Q1 by using the first capacitor C1;
a gate of the fourth PMOS transistor Q4 is connected to the negative input end of the complementary common-source input stage, a source of the fourth PMOS transistor Q4 is connected to a power supply end, and the drain of the fourth PMOS transistor Q4 is connected to a source of the second NMOS transistor Q2 by using the second capacitor C2;
a center tap of the second inductor L2 is connected to the ground, and
the second inductor L2 is connected in parallel to the fifth variable capacitor C5;
the source of the first NMOS transistor Q1 is connected to the source of the second NMOS transistor Q2 by using the fifth variable capacitor C5, the source of the first NMOS transistor Q1 is further connected to a gate of the second NMOS transistor Q2 by using the third capacitor C3, and
a gate of the first NMOS transistor Q1 is further connected to the gate of the second NMOS transistor Q2 by using the third resistor and the fourth resistor;
a drain of the first NMOS transistor Q1 is connected to a source of the seventh NMOS transistor Q7, and
the source of the second NMOS transistor Q2 is further connected to the gate of the first NMOS transistor Q1 by using the fourth capacitor C4;
a drain of the second NMOS transistor Q2 is connected to a source of the eighth NMOS transistor Q8;
a drain of the seventh NMOS transistor Q7 is connected to a drain of the eighth NMOS transistor Q8 by using the sixth variable capacitor C6; and
a gate of the seventh NMOS transistor Q7 is connected to a gate of the eighth NMOS transistor Q8,
the sixth variable capacitor C6 is connected in parallel to the first inductor L1,
a center tap of the first inductor L1 is connected to a power supply end,
the drain of the seventh NMOS transistor Q7 is a positive output end of the common-gate output stage, and
the drain of the eighth NMOS transistor Q8 is a negative output end of the common-gate output stage.

12. The amplifier according to claim 6, wherein
the complementary common-source input stage comprises:
a first resistor RF1, a third PMOS transistor Q3, and a fifth NMOS transistor Q5;
the inter-stage matching and coupling network comprises a first capacitor C1, a fifth variable capacitor C5, and a second inductor L2; and
the common-gate output stage comprises:
a first inductor L1, a third capacitor C3, a fourth capacitor C4, a first NMOS transistor Q1, a second NMOS transistor Q2, a third resistor R3, a fourth resistor R4, a sixth variable capacitor C6, a seventh NMOS transistor Q7, and an eighth NMOS transistor Q8, wherein
a gate of the fifth NMOS transistor Q5 is connected to a positive input end of the complementary common-source input stage, a drain of the fifth NMOS transistor Q5 is connected to the positive input end of the complementary common-source input stage by using the first resistor RF1, a source of the fifth NMOS transistor Q5 is connected to the ground, and the drain of the fifth NMOS transistor Q5 is further connected to a drain of the third PMOS transistor Q3;
a gate of the third PMOS transistor Q3 is connected to the positive input end of the complementary common-source input stage, a source of the third PMOS transistor Q3 is connected to a power supply end, and the drain of the third PMOS transistor Q3 is connected to a source of the first NMOS transistor Q1 by using the first capacitor C1;
a center tap of the second inductor L2 is connected to the ground, and
the second inductor L2 is connected in parallel to the fifth variable capacitor C5;
the source of the first NMOS transistor Q1 is connected to a source of the second NMOS transistor Q2 by using the fifth variable capacitor C5, the source of the first NMOS transistor Q1 is further connected to a gate of the second NMOS transistor Q2 by using the third capacitor C3, and
a gate of the first NMOS transistor Q1 is further connected to the gate of the second NMOS transistor Q2 by using the third resistor and the fourth resistor;
a drain of the first NMOS transistor Q1 is connected to a source of the seventh NMOS transistor Q7, and
the source of the second NMOS transistor Q2 is further connected to the gate of the first NMOS transistor Q1 by using the fourth capacitor C4;
a drain of the second NMOS transistor Q2 is connected to a source of the eighth NMOS transistor Q8;
a drain of the seventh NMOS transistor Q7 is connected to a drain of the eighth NMOS transistor Q8 by using the sixth variable capacitor C6; and
a gate of the seventh NMOS transistor Q7 is connected to a gate of the eighth NMOS transistor Q8,
the sixth variable capacitor C6 is connected in parallel to the first inductor L1,
a center tap of the first inductor L1 is connected to a power supply end,
the drain of the seventh NMOS transistor Q7 is a positive output end of the common-gate output stage, and
the drain of the eighth NMOS transistor Q8 is a negative output end of the common-gate output stage.

13. A receiver, wherein the receiver comprises the low noise amplifier according to any one of claims 6 to 12.
